# EUROPEAN PATENT APPLICATION

(11) **EP 4 852 320 A1**
(43) Date of publication of application: **09.12.2026**
(21) Application number: 25767275.8
(22) Date of filing: 28.02.2025
(51) Int. Cl.: H03H 9/54

(54) **PACKAGED CHIP, RADIO FREQUENCY COMMUNICATION MODULE, AND COMMUNICATION DEVICE**

(30) Priority: 08.03.2024 CN 202410269371
(71) Applicant: HUAWEI TECHNOLOGIES CO., LTD., Shenzhen, Guangdong 518129 (CN)
(72) Inventor: WU, Han, Shenzhen, Guangdong 518129 (CN); ZHOU, Xin, Shenzhen, Guangdong 518129 (CN); ZHANG, Xiaofeng, Shenzhen, Guangdong 518129 (CN); TANG, Qingwu, Shenzhen, Guangdong 518129 (CN); MA, Zhifeng, Shenzhen, Guangdong 518129 (CN)
(74) Representative: Huawei European IPR
(86) International application number: PCT/CN2025/079948
(87) International publication number: WO 2025/185536

(57) **Abstract**

Embodiments of this application provide a packaged chip, a radio frequency communication module, and a communication device, used in the field of semiconductor packaging technologies. The packaged chip includes a wafer. The packaged chip further includes at least one first attenuating element and at least one first tuning element, the first attenuating element is an equivalent capacitor or an equivalent resistor, and the first tuning element is an equivalent capacitor, an equivalent inductor, or an equivalent resistor. A filter structure is formed on the wafer, and the filter structure includes a first filter resonant structure. The at least one first attenuating element is connected to a first end and a second end of the first filter resonant structure, to form a parallel structure with the first filter resonant structure. A first end of each first tuning element is connected to a transmission path formed by the first end and the second end of the first filter resonant structure and the at least one first attenuating element, and a second end of each first tuning element is grounded. Embodiments of this application greatly improve rejection and/or isolation of a filter component without increasing insertion loss.

## Description

This application claims priority to Chinese Patent Application No. 202410269371.3, filed with the China National Intellectual Property Administration on March 8, 2024 and entitled "PACKAGED CHIP, RADIO FREQUENCY COMMUNICATION MODULE, AND COMMUNICATION DEVICE", which is incorporated herein by reference in its entirety.

### TECHNICAL FIELD

This application relates to the field of semiconductor packaging technologies, and in particular, to a packaged chip, a radio frequency communication module, and a communication device.

### BACKGROUND

In communication systems (for example, wireless communication systems or power carrier communication systems) operating based on communication signals, related components typically are required to perform signal processing, for example, filtering processing, on communication signals. In conventional technologies, numerous packaging techniques are required for manufacturing semiconductor filter components. In the existing design of semiconductor acoustic wave filter components, there is a problem of spatial leakage. Regardless of a packaging technique to be used, the problem of spatial leakage caused by a structure of the semiconductor component cannot be avoided.

In related conventional technologies, spatial leakage may be reduced by adding a packaging process, or rejection and/or isolation of the filter component may be increased based on a semiconductor design structure, for example, zero-point cavities. However, these approaches offer limited performance improvements and invariably increase the insertion loss of the filter component.

### SUMMARY

Embodiments of this application provide a packaged chip, a radio frequency communication module, and a communication device, to greatly increase rejection and/or isolation of a filter component without increasing insertion loss.

To achieve the foregoing objectives, the following technical solutions are used in embodiments of this application.

According to a first aspect, a packaged chip is provided, where the packaged chip includes a wafer. The packaged chip further includes at least one first attenuating element and at least one first tuning element, the first attenuating element is an equivalent capacitor or an equivalent resistor, and the first tuning element is an equivalent capacitor, an equivalent inductor, or an equivalent resistor. A filter structure is formed on the wafer, and the filter structure includes a first filter resonant structure. The at least one first attenuating element is connected to a first end and a second end of the first filter resonant structure, to form a parallel structure with the first filter resonant structure. A first end of each first tuning element is connected to a transmission path formed by the first end and the second end of the first filter resonant structure and the at least one first attenuating element, and a second end of each first tuning element is grounded.

In this embodiment of this application, the at least one first attenuating element is connected in parallel to the two ends of the first filter resonant structure to form an attenuation transmission path. In addition, the at least one first tuning element is short-circuited on the transmission path. The first attenuating element and the first tuning element may form a tuning structure with the first filter resonant structure. In addition, a coupling path is formed in the packaged chip based on the first attenuating element and the short-circuited first tuning element, and the coupling path may form a tuning structure with spatial leakage at a position of the coupling path. For a radio frequency signal within a stopband frequency range, a resonant circuit structure equivalent to the coupling path is presented as an open circuit, and a transmission zero may be generated. In this implementation, a transmission zero with a large depth can be obtained, to achieve a great rejection effect and isolation effect. Both the attenuating element and the tuning element used in this solution may be compatible with an existing mature packaging manufacturing process, and no manufacturing process is added. In addition, application of this implementation solution does not increase signal insertion loss of a filter component.

In a possible implementation, when the at least one first attenuating element includes a plurality of first attenuating elements, the plurality of first attenuating elements are connected in series and/or in parallel. In this embodiment of this application, the plurality of first attenuating elements may be designed in series and/or in parallel based on different signal frequencies in an application scenario, different selections of packaged chips on which an application is based, different designs of packaging structures, and the like. In embodiments of this application, high rejection and high isolation can be implemented with design flexibility.

In a possible implementation, the filter structure further includes a second filter resonant structure. A first end of the second filter resonant structure is connected to the second end of the first filter resonant structure. In this embodiment of this application, the first filter resonant structure may be a part of filter resonant structures in the filter structure. The part of filter resonant structures (that is, the first filter resonant structure) may be tuned based on the coupling path formed by the first attenuating element and the first tuning element. In addition, the spatial leakage at the position of the coupling path may be tuned.

In some examples, the packaged chip further includes at least one second attenuating element and at least one second tuning element, the second attenuating element is an equivalent capacitor or an equivalent resistor, and the second tuning element is an equivalent capacitor, an equivalent inductor, or an equivalent resistor. The at least one second attenuating element is connected to the first end and a second end of the second filter resonant structure, to form a parallel structure with the second filter resonant structure. A first end of each second tuning element is connected to a transmission path formed by the first end and the second end of the second filter resonant structure and the at least one second attenuating element, and a second end of each second tuning element is grounded. In this embodiment of this application, coupling paths based on the attenuating element and the tuning element may be separately designed for a plurality of filter resonant structure parts in the filter structure. Different coupling paths may be disposed at different structural positions. In addition, coupling paths of different parameters may also be correspondingly designed for different filter resonant structures, to achieve a better performance improvement effect.

In a possible implementation, based on different structures of packaged chips based on semiconductor technologies, and based on different packaging technologies of the packaged chips, a tuning element and/or an attenuating element may be designed at different positions of the packaged chip.

In some examples, the at least one first attenuating element and/or the at least one first tuning element are/is formed on the wafer, each first attenuating element and the filter structure are located on a same surface or different surfaces of the wafer, and each first tuning element and the filter structure are located on a same surface or different surfaces of the wafer. In this embodiment of this application, the tuning element and the attenuating element may be designed on the wafer. A coupling path formed by the tuning element and the attenuating element may tune the filter structure, and also tune spatial leakage at a position of the wafer in the packaged chip.

For example, packaging of the filter structure is implemented based on a die-sized surface acoustic wave packaging (die-sized SAW packaging, DSSP) technology. A cavity structure is formed on the wafer, and the filter structure is disposed in the cavity structure. In this case, the packaged chip may not be designed with a package substrate. The tuning element and the attenuating element may be disposed in cavity structures of the wafer, and the spatial leakage caused by the cavity structures is tuned based on the coupling path formed by the tuning element and the attenuating element.

In some examples, the packaged chip further includes the package substrate. The at least one first attenuating element and/or the at least one first tuning element are/is formed on the package substrate. The packaged chip further includes a metal connection structure. The metal connection structure is connected to the first end of the first filter resonant structure, the at least one first attenuating element, and the second end of the first filter resonant structure, to form a transmission path connecting the first end of the first filter resonant structure, the at least one first attenuating element, and the second end of the first filter resonant structure. The metal connection structure is further connected to a first end of the at least one first tuning element, so that the first end of each first tuning element is connected to the transmission path formed by the first end and the second end of the first filter resonant structure and the at least one first attenuating element. In this embodiment of this application, the packaged chip manufactured by using some packaging technologies includes the wafer and the package substrate. In this case, some or all elements may be disposed on the package substrate. According to one aspect, area overheads on the wafer can be reduced, and an area of the packaged chip is prevented from increasing due to a substantial increase in an area of the wafer. According to another aspect, these elements (for example, the tuning element and/or the attenuating element), when disposed on the package substrate, may also form tuning with some spatial leakage at a position of the package substrate.

In different packaging technologies, different metal connection structures may be designed to implement an electrical connection between the filter structure on the wafer and the elements on the package substrate.

For example, packaging of the filter structure is implemented based on a chip scale package (chip scale package, CSP) technology. When the at least one first tuning element is formed on the package substrate, the metal connection structure includes a first bump, a second bump, a first solder joint, a second solder joint, and a first metal line. The first bump and the second bump are disposed on the wafer. The first solder joint and the second solder joint are disposed on a first surface of the package substrate. The first bump is connected to the first end of the first filter resonant structure, and the second bump is connected to the second end of the first filter resonant structure. The first bump is bonded to the first solder joint, and the second bump is bonded to the second solder joint. The first solder joint is connected to the second solder joint through the first metal line, to form a transmission path connecting the first end of the first filter resonant structure, the first bump, the second bump, and the second end of the first filter resonant structure and the at least one first attenuating element. The first end of each first tuning element is electrically connected to the first metal line, and the second end of the first tuning element is grounded. In this embodiment of this application, in a CSP-based packaging technology, packaging attachment between the wafer and the package substrate are usually implemented based on a bump and a solder joint. Therefore, the electrical connection between the filter structure on the wafer and the elements on the package substrate may also be implemented based on the bump and the solder joint as the metal connection structures. In addition, a transmission path formed based on the metal connection structures may be tuned with spatial leakage at a corresponding position, to reduce the spatial leakage and improve rejection, isolation, and the like.

For example, packaging of the filter structure is implemented based on a surface mount device (surface mount device, SMD) technology or a wafer-level packaging (wafer-level packaging, WLP) technology. When the at least one first tuning element is formed on the package substrate, and the metal connection structure includes a first metal jumper or a metal post. When the SMD technology is used, the first end of the at least one first tuning element is connected to a first end of the first metal jumper, and a second end of the first metal jumper is connected to the transmission path formed by the first end and the second end of the first filter resonant structure and the at least one first attenuating element. Alternatively, when the WLP technology is used, the first end of the at least one first tuning element is connected to a first end of the metal post, and a second end of the metal post is connected to the transmission path formed by the first end and the second end of the first filter resonant structure and the at least one first attenuating element. In this embodiment of this application, in the SMD technology, the electrical connection between the package substrate and the filter structure on the wafer is implemented based on a metal jumper. When the SMD technology is used, large cavity structures exist between the package substrate and the wafer. Therefore, spatial leakage caused by the cavity structures may be tuned based on a coupling path formed by the tuning element and the attenuating element. Similarly, when the WLP technology is used, cavity structures are also formed between the package substrate and the wafer, and the filter structure is disposed in the cavity structures. In this case, spatial leakage caused by the cavity structures may also be tuned based on a coupling path formed by the tuning element and the attenuating element.

When the packaged chip includes the package substrate, in some examples, the filter structure may be disposed on a surface of the wafer. In some examples, cavity structures are formed on the wafer, and the filter structure may be disposed in the cavity structures. The at least one first tuning element is formed on the package substrate. A structure of the wafer is not limited in this embodiment of this application.

In a possible implementation, an equivalent inductor used as an attenuating element may be obtained based on different structures.

In an example, any equivalent inductor is a winding coil or a short-circuited transmission line, and a target electrical length of the short-circuited transmission line is less than 90°. The target electrical length is an electrical length of the short-circuited transmission line at a lowest cut-off frequency in a corresponding filter passband range. The equivalent inductor is disposed at any one of the following positions of the package substrate: a first surface of the package substrate, an inner layer of the package substrate, or a second surface of the package substrate. In this embodiment of this application, the equivalent inductor may be designed based on inductance of the winding coil or the short-circuit transmission line. To ensure normal operation of filtering, it needs to be ensured that the target electrical length of the short-circuit transmission line is less than 90°. The winding coil and the short-circuit transmission line are conventional manufacturing structures in a semiconductor packaging process, and the equivalent inductor may be processed and manufactured based on an existing semiconductor filter component process.

In an example, any equivalent inductor is a via structure. A first end of the via structure extends from an inner layer of the package substrate to a first surface of the package substrate, the first end of the via structure is connected to a first metal transmission line, and a second end of the via structure is grounded. In this embodiment of this application, the via structure is a metal hole structure, and the equivalent inductor may be designed based on an inductance characteristic of the hole structure. In addition, a via is a conventional manufacturing structure in the semiconductor packaging process, and the equivalent inductor may be processed and manufactured based on the existing semiconductor filter component process.

In a possible implementation, the at least one first attenuating element is disposed at any one of the following positions of the package substrate: a first surface of the package substrate, an inner layer of the package substrate, or a second surface of the package substrate. In this embodiment of this application, the first attenuating element may be disposed at different positions of the package substrate. A connection between the filter structure and the attenuating element, the tuning element, and the like is implemented based on a metal connection structure designed in a corresponding packaging technology.

In a possible implementation, the filter structure includes a plurality of external ends. A plurality of external metal connection structures are further disposed on a second surface of the wafer. The plurality of external ends are connected to first ends of the plurality of external metal connection structures in one-to-one correspondence. Second ends of a plurality of external via transmission structures extend to outside the package substrate and are coupled to a plurality of external chip terminals in one-to-one correspondence. The plurality of external chip terminals are external communication ports of the packaged chip. In this embodiment of this application, different external metal connection structures may be designed based on different packaging technologies. The filter structure on the wafer in the packaged chip is electrically connected to the outside of the packaged chip based on the external metal connection structure.

In a possible implementation, the packaged chip is a filter chip, a different-frequency power splitter chip, a multiplexer chip, an integrated radio frequency switch, or an amplifier. In this embodiment of this application, different components in a communication system may use a semiconductor filter component.

According to a second aspect, an embodiment of this application provides a radio frequency communication module. The radio frequency communication module includes a printed circuit board, a packaged chip, and a metal connection structure. The packaged chip further includes at least one first attenuating element. The printed circuit board is provided with a first tuning element. The first attenuating element is an equivalent capacitor or an equivalent resistor, and the first tuning element is an equivalent capacitor, an equivalent inductor, or an equivalent resistor. The packaged chip includes a wafer and a package substrate. A filter structure is formed on the wafer, and the filter structure includes a first filter resonant structure. The package substrate is provided with at least one external via transmission structure. The at least one first attenuating element is connected to a first end and a second end of the first filter resonant structure, to form a parallel structure with the first filter resonant structure. A first end of the at least one external via transmission structure is connected to a transmission path formed by the first end and the second end of the first filter resonant structure and the at least one first attenuating element, a second end of the at least one external via transmission structure is connected to a first end of the at least one first tuning element, and a second end of the at least one first tuning element is grounded.

In this embodiment of this application, different values of the tuning element may result in different positions of a transmission zero. The tuning element is disposed on the printed circuit board, so that the tuning element is not limited by an area size of the packaged chip, and the like. For example, a lumped inductor may be used as the tuning element. In addition, the tuning element may be further replaced, or a parameter control change may be implemented, to implement adaptation to different application scenarios, or implement adjustment of different performance, or the like.

In a possible implementation, when the at least one first attenuating element includes a plurality of first attenuating elements, the plurality of first attenuating elements are connected in series and/or in parallel.

In a possible implementation, the first attenuating element is disposed at any one of the following positions of the radio frequency communication module: the wafer, the package substrate, and the printed circuit board. In this embodiment of this application, when the tuning element is disposed on the printed circuit board, the attenuating element may be designed at different positions based on a design requirement.

In a possible implementation, the packaged chip is at least one of the following: a filter chip, a different-frequency power splitter chip, a multiplexer chip, an integrated radio frequency switch, or an amplifier.

According to a third aspect, an embodiment of this application further provides a radio frequency communication module. The radio frequency communication module includes a printed circuit board and the packaged chip described in the foregoing first aspect.

According to a fourth aspect, an embodiment of this application further provides a communication device. The communication device includes a device housing and a radio frequency communication module. The radio frequency communication module is partially or entirely disposed in the device housing, and the radio frequency communication module is the radio frequency communication module described in the foregoing second aspect, or the radio frequency communication module described in the foregoing third aspect.

For technical principles and beneficial effects of the foregoing second aspect, third aspect, and fourth aspect, refer to related descriptions of the foregoing first aspect. Details are not described herein again.

### BRIEF DESCRIPTION OF DRAWINGS

FIG. 1 is a diagram of a structure of a communication system according to an embodiment of this application;
FIG. 2a, FIG. 2b, and FIG. 2c are diagrams of several semiconductor structures of resonators according to an embodiment of this application;
FIG. 3a, FIG. 3b, and FIG. 3c are schematics of circuit principles of several resonator-based semiconductor components according to an embodiment of this application;
FIG. 4 is a diagram of a structure of a radio frequency communication module according to an embodiment of this application;
FIG. 5a and FIG. 5b are diagrams of structures of processing a resonator-based filter structure on a wafer according to an embodiment of this application;
FIG. 6a, FIG. 6b, FIG. 6c, and FIG. 6d are diagrams of structures of several packaging structures for processing a packaged chip based on a semiconductor packaging technology according to an embodiment of this application;
FIG. 7a and FIG. 7b are diagrams of structures of two implementations of providing performance of a filter structure by adding a transmission zero according to an embodiment of this application;
FIG. 8 is a diagram of a rejection improvement effect before and after a structure shown in FIG. 7a is applied according to an embodiment of this application;
FIG. 9 is a diagram of forming a coupling path based on a first attenuating element and a first tuning element according to an embodiment of this application;
FIG. 10 is a schematic of an equivalent resonance principle of a signal in a stopband frequency range based on a coupling path shown in FIG. 9 according to an embodiment of this application;
FIG. 11 is a diagram of a filtering effect based on a structure shown in FIG. 9 according to an embodiment of this application;
FIG. 12a, FIG. 12b, FIG. 12c, FIG. 12d, FIG. 12e, FIG. 12f, FIG. 12g, FIG. 12h, and FIG. 12i are diagrams of different design manners of a first attenuating element and a first tuning element according to an embodiment of this application;
FIG. 13a and FIG. 13b are diagrams of structures of a filter structure including a first filter resonant structure and a second filter resonant structure according to an embodiment of this application;
FIG. 14a, FIG. 14b, FIG. 14c, FIG. 14d, FIG. 14e, and FIG. 14f are diagrams of structures of a filter structure including different filter resonant structures according to an embodiment of this application;
FIG. 15a, FIG. 15b, FIG. 15c, and FIG. 15d are diagrams of structures of a filter structure based on different selection designs according to an embodiment of this application;
FIG. 16a and FIG. 16b are diagrams of structures when a tuning element and an attenuating element are designed on a wafer according to an embodiment of this application;
FIG. 17a, FIG. 17b, FIG. 17c, and FIG. 17d are diagrams of structures when a tuning element or a tuning element and an attenuating element are designed on a package substrate according to an embodiment of this application;
FIG. 18a, FIG. 18b, FIG. 18c, and FIG. 18d are diagrams of different selection structures of an equivalent inductor according to an embodiment of this application;
FIG. 19 is a diagram of a signal rejection effect of a structure shown in FIG. 17 according to an embodiment of this application;
FIG. 20 is a diagram of a receive and transmit isolation effect of a structure shown in FIG. 17 according to an embodiment of this application;
FIG. 21 is a diagram of a signal insertion loss effect of a structure shown in FIG. 17 according to an embodiment of this application;
FIG. 22 is a diagram of a structure of a tuning element disposed on a printed circuit board according to an embodiment of this application; and
FIG. 23a and FIG. 23b are diagrams of structures of a packaged chip and a tuning element that are disposed on a printed circuit board and that are of a dual-channel filter according to an embodiment of this application.

### DESCRIPTION OF EMBODIMENTS

It should be noted that terms such as "first" and "second" in embodiments of this application are merely used to distinguish between features of a same type, and cannot be understood as an indication of relative importance, a quantity, a sequence, or the like.

The term "example", "for example", or the like in embodiments of this application is used to represent giving an example, an illustration, or a description. Any embodiment or design scheme described as an "example" or "for example" in this application should not be explained as being more preferred or having more advantages than another embodiment or design scheme. To be precise, use of the words such as "example" or "for example" is intended to present a relevant concept in a specific manner.

The terms "coupling" and "connection" in embodiments of this application should be understood in a broad sense, for example, may refer to a physical direct connection, or may refer to an indirect connection implemented by using an electronic component, for example, a connection implemented by using a resistor, an inductor, a capacitor, a microstrip, a strip line, a coupler, a bump, a via, a solder pad, a solder joint, a metal line, or another electronic component.

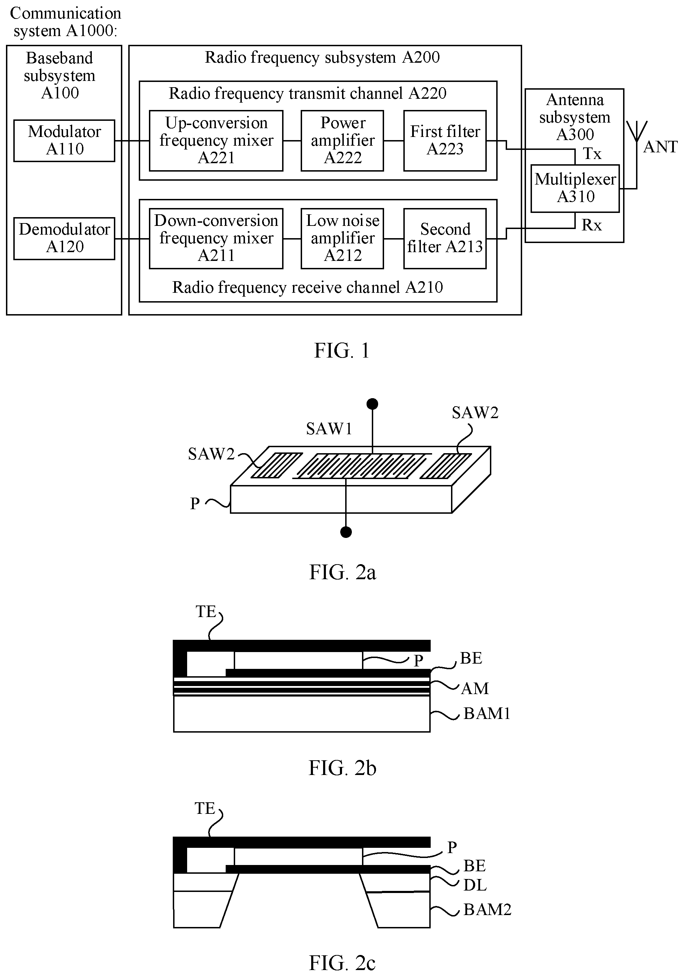

An embodiment of this application provides an example of a communication system in FIG. 1. As shown in FIG. 1, a communication system A1000 includes a baseband subsystem A100, a radio frequency subsystem A200, and an antenna subsystem A300. The antenna subsystem A300 includes a multiplexer A310 and an antenna ANT. The radio frequency subsystem A200 includes a radio frequency receive channel A210 and a radio frequency transmit channel A220. The baseband subsystem A100 includes a modulator A110 and a demodulator A120. The radio frequency receive channel A210 is separately connected to the demodulator A120 and the multiplexer A310. The radio frequency transmit channel A220 is separately coupled to the demodulator A120 and the multiplexer A310.

The modulator A110 may modulate an input baseband signal, to obtain a modulated intermediate frequency signal, and send the intermediate frequency signal to the radio frequency transmit channel A220. The radio frequency transmit channel A220 includes an up-conversion frequency mixer A221, a power amplifier A222, and a first filter A223. The up-conversion frequency mixer A221 is configured to perform up-conversion processing on the intermediate frequency signal, to obtain a transmit radio frequency signal. After the power amplifier A222 performs power amplification processing on the transmit radio frequency signal, and the first filter A223 performs bandpass filtering processing on the transmit radio frequency signal, the radio frequency transmit channel A220 outputs a processed transmit radio frequency signal to the antenna subsystem A300. The multiplexer A310 in the antenna subsystem A300 may receive the transmit radio frequency signal from the radio frequency transmit channel A220, and transmit the transmit radio frequency signal via a radiator of the antenna ANT.

The multiplexer A310 in the antenna subsystem A300 may further receive, via the radiator of the antenna ANT, a receive radio frequency signal transmitted by another wireless communication device, and send the receive radio frequency signal to the radio frequency receive channel A210. The radio frequency receive channel A210 includes a down-conversion frequency mixer A211, a low noise amplifier A212, and a second filter A213. The second filter A213 performs bandpass filtering processing on the receive radio frequency signal sent by the multiplexer A310 in the antenna subsystem A300, to filter out a clutter signal. The low noise amplifier A212 performs power amplification processing on a filtered receive radio frequency signal. The down-conversion frequency mixer A211 performs down-conversion processing on the power amplification processed receive radio frequency signal, to obtain an intermediate frequency signal. The demodulator A120 of the baseband subsystem A100 demodulates the intermediate frequency signal received from the down-conversion frequency mixer A211, to obtain a demodulated baseband signal.

For example, oscillators may be respectively disposed for the modulator A110 and the demodulator A120, to correspondingly provide local oscillator signals required for modulation and demodulation. For example, oscillators may be respectively disposed for the up-conversion frequency mixer A221 and the down-conversion frequency mixer A211, to correspondingly provide local oscillator signals required for up-conversion and down-conversion.

In the application scenario architecture shown in FIG. 1, filtering processing may be involved in many components. In this embodiment of this application, examples of several common filtering processing scenarios are provided below.

Scenario 1: In the architecture in FIG. 1, the first filter A223 and the second filter A213 need to perform bandpass filtering processing on the input radio frequency signals. Therefore, corresponding filter circuit structures need to be designed in bandpass filter components such as the first filter A223 and the second filter A213.

Scenario 2: In the architecture in FIG. 1, the multiplexer A310 needs to receive the transmit radio frequency signal from the radio frequency transmit channel A220 and send the transmit radio frequency signal via the antenna ANT, and needs to receive and obtain the receive radio frequency signal from the antenna ANT and send the receive radio frequency signal to the radio frequency receive channel A210. Therefore, a corresponding filter circuit structure needs to be designed in the multiplexer A310, to separately implement filtering on the receive radio frequency signal and the transmit radio frequency signal, and implement receive and transmit isolation between a receive path and a transmit path.

Scenario 3: In the architecture in FIG. 1, when some power amplifiers A222 are designed to perform power amplification on transmit radio frequency signals of a plurality of frequency bands, for example, are designed as doherty (doherty) architecture-based multi-frequency shared power amplifiers, the transmit radio frequency signals of the plurality of frequency bands may share some or all power amplification circuit structures in the power amplifiers A222 for power amplification. In the multi-frequency shared power amplifier, a different-frequency power splitter with a filter design structure may also be used. In addition, in another application scenario of the communication system A1000, the different-frequency power splitter with the filter design structure may also be used, to implement corresponding frequency division processing.

The foregoing examples in this embodiment of this application are merely examples for description. In actual practice, there is another scenario in which corresponding filtering processing needs to be performed on a radio frequency signal based on a filter circuit structure (for example, an integrated radio frequency switch or a low noise amplifier). Alternatively, in an application scenario of power line communication (power line communication, PLC), a duplexer and a filter are also required to perform receive and transmit isolation, filtering processing, and other processing on a communication signal. Examples are not described one by one in this embodiment of this application.

Semiconductor technology-based filter circuit structures may be processed and designed on a packaged chip, and may be usually classified into a surface acoustic wave (surface acoustic wave, SAW) filter, a bulk acoustic wave (bulk acoustic wave, BAM) filter, a film bulk acoustic resonator (film bulk acoustic resonator, FBAR) filter, and the like. These semiconductor technology-based filters are all composed of resonators. Although different types of filters may be based on different structures and materials of resonators, a plurality of resonators form filter resonant structures in these filters in forms of ladder (ladder) topology structures, to obtain filter structures of semiconductor filters. FIG. 2a, FIG. 2b, and FIG. 2c provide examples of diagrams of structures of different resonators.

A structure of a SAW resonator is shown in FIG. 2a. One SAW resonator includes a piezoelectric material (piezoelectric) P, an interdigital structure SAW1, and metal reflectors (reflector) SAW2. The interdigital structure SAW1 and the two metal reflectors SAW2 are disposed on a surface of the piezoelectric material P. The interdigital structure SAW1 is made of a metal material and may be used as an interdigital transducer (interdigital transducer, IDT). Two ends of the IDT are respectively designed in parallel with the two metal reflectors SAW2. Two electrodes may be led out from two sides of the interdigital structure SAW1 that is used as the IDT, to serve as a first end and a second end of the SAW resonator for transmission of an electrical signal.

A structure of a BAW resonator is shown in FIG. 2b. One BAW resonator includes a top electrode (top electrode) TE, a piezoelectric material P, a bottom electrode (bottom electrode) BE, an acoustic mirror (acoustic mirror) AM, and a substrate BAM1. The acoustic mirror AM is disposed on the substrate BAM1. A top and a bottom of the piezoelectric material P are respectively correspondingly connected to the top electrode TE and the bottom electrode BE, the bottom electrode BE is disposed on the acoustic mirror AM, and the top electrode TE is connected to the acoustic mirror AM. The bottom electrode BE and the top electrode TE are used as a first end and a second end of the BAW resonator for transmission of an electrical signal.

A structure of an FBAR resonator is shown in FIG. 2c. One FBAR resonator includes a top electrode (top electrode) TE, a piezoelectric material P, a bottom electrode (bottom electrode) BE, a dielectric layer (dielectric layer) DL, and a substrate BAM2. The dielectric layer DL is installed on the substrate BAM2, and an air cavity (air cavity) is formed by processing middle sections of the dielectric layer DL and the substrate BAM2. The bottom electrode BE is disposed on the dielectric layer DL and crosses the air cavity. A top and a bottom of the piezoelectric material P are respectively correspondingly connected to the top electrode TE and the bottom electrode BE, and the top electrode TE is connected to the dielectric layer DL. The bottom electrode BE and the top electrode TE are used as a first end and a second end of the FBAR resonator for transmission of an electrical signal.

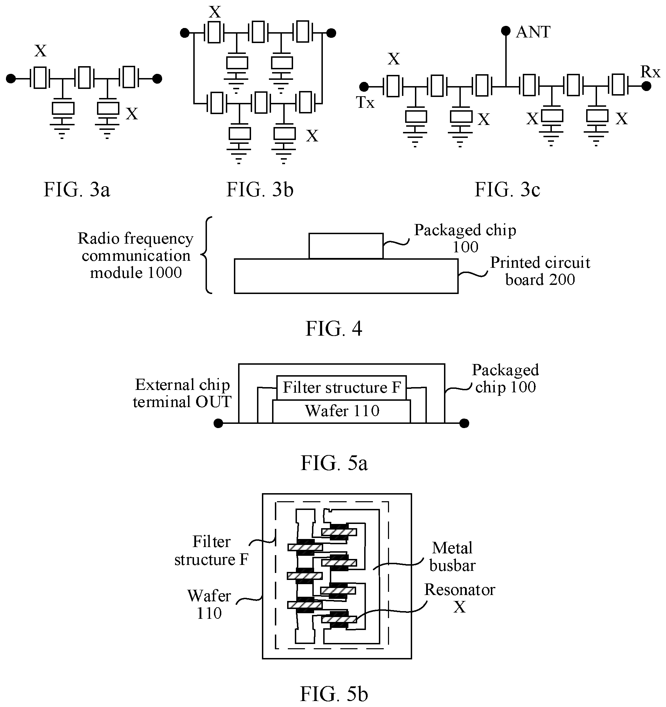

It can be learned from the foregoing descriptions of FIG. 2a, FIG. 2b, and FIG. 2c that each resonator includes the first end and the second end that are configured to implement transmission of the electrical signal. It is described above that a plurality of resonators form filter resonant structures in various types of filters in forms of ladder (ladder) topology structures. As shown in FIG. 3a, FIG. 3b, and FIG. 3c, the foregoing different types of resonators are generally represented by using patterns in which a piezoelectric material and two electrodes are parallel. A plurality of resonators X may form a filter resonant structure based on a ladder structure topology, or some SAW resonators may form a filter resonant structure based on a double-mode SAW (double-mode SAW, DMS) structure. Generally, a quantity of resonators X that are alternately arranged in series and parallel in the filter resonant structure formed in the ladder structure topology represents an order of the filter resonant structure. For example, as shown in FIG. 3a, a 5-order filter resonant structure is formed by alternately arranging three series-connected resonators X and two parallel-connected resonators X in series and parallel. The resonant structure may be used as a filter, or a filter structure required by another component in the foregoing application scenario. As shown in FIG. 3b, a dual-pass filter resonant structure is formed by two 5-order filter resonant structures. When the two 5-order filter resonant structures respectively allow radio frequency signals in different frequency ranges to pass through, the dual-pass filter resonant structure may be used as a filter structure of a dual-passband filter or another component. As shown in FIG. 3c, a filter structure is formed by connecting two 5-order filter resonant structures. A first end of one 5-order filter resonant structure and a second end of the other 5-order filter resonant structure are respectively used as a first external end and a second external end of the filter structure, and a third external end of the filter structure may be disposed at a joint between the two 5-order filter resonant structures. In actual designs, the filter structure shown in FIG. 3c may be used as a component varying with different designs of transmission directions and transmission frequencies of signals at the three external ends. For example, when the first external end is configured to transmit a radio frequency signal of a first frequency band, the second external end is configured to transmit a radio frequency signal of a second frequency band, and the third external end is configured to transmit radio frequency signals of the first frequency band and the second frequency band, FIG. 3c may be designed as a duplexer. For example, the first external end is used as an input end Tx of the duplexer to receive the radio frequency signal of the first frequency band, and the third external end is used as an antenna connection end of the duplexer and is connected to an antenna ANT to transmit the radio frequency signal of the first frequency band to the antenna ANT. The second external end is used as a receive end Rx of the duplexer, to transmit, to the second external end, the radio frequency signal of the second frequency band that is received from the antenna ANT via the third external end. Alternatively, the filter structure shown in FIG. 3c may be designed as a different-frequency power splitter (or a different-frequency power combiner), or the like. Although not shown in FIG. 3a, FIG. 3b, and FIG. 3c, in actual practice, a capacitor may be used to replace a part of the resonators X (for example, replace a part of the resonators X connected in series) in the ladder topology.

Embodiments of this application provide a communication device. The communication device includes a device housing and a radio frequency communication module. The radio frequency communication module is partially or entirely disposed in the device housing. The radio frequency communication module is configured to implement receiving and sending of a radio frequency signal and signal processing.

In some examples, the radio frequency communication module may include one or more components in the radio frequency subsystem A200 shown in FIG. 1. In some examples, the radio frequency communication module may also include one or more components in the antenna subsystem A300 shown in FIG. 1.

As shown in FIG. 4, a radio frequency communication module 1000 includes a packaged chip 100 and a printed circuit board 200. The packaged chip 100 is disposed on the printed circuit board 200. The packaged chip 100 has a semiconductor technology-based filter structure. The packaged chip 100 may implement a filtering processing function on a radio frequency signal or another type of communication signal based on the filter structure.

For example, the packaged chip 100 may be a filter chip, a different-frequency power splitter chip, a multiplexer chip, an integrated radio frequency switch, a low noise amplifier, a power amplifier, and the like that are described as examples in the application scenarios in FIG. 1, FIG. 2a to FIG. 2c, and FIG. 3a to FIG. 3c.

As shown in FIG. 5a, a packaged chip 100 includes a wafer (wafer) 110. A filter structure F is formed on the wafer 110. An external end of the filter structure F is electrically connected to an external chip terminal OUT outside of the packaged chip 100, to implement electrical signal transmission and interaction between the filter structure inside the packaged chip 100 and an outside of the packaged chip 100. For example, the filter structure is the 5-order filter resonant structure shown in FIG. 3a. A resonator X1, a resonator X2, a resonator X3, a resonator X4, and a resonator X5 in the filter resonant structure may be separately disposed on the wafer 110 (and may be disposed on a surface of the wafer 110 or in an air cavity inside the wafer 110 based on different packaging technologies). As shown in FIG. 5b, a metal busbar (busbar) may be used to implement an electrical connection between a plurality of resonators X. Then, after packaging processing is performed on the filter structure F by using a packaging technology, and an external metal connection structure is formed, the external end of the filter structure F is electrically connected to the external chip terminal OUT of the packaged chip 100 via the external metal connection structure. The formed external metal connection structure may vary with different packaging manufacturing technologies.

In related semiconductor packaging technologies, there are many packaging manufacturing technologies that can implement manufacturing of the filter structure, for example, a chip scale package (chip scale package, CSP) technology, a wafer-level packaging (wafer-level packaging, WLP) technology, a surface mount device (surface mount device, SMD) packaging technology, and a die-sized surface acoustic wave packaging (die-sized SAW packaging, DSSP) technology. In some wafer-level and die-sized packaging manners, the wafer 110 may be directly packaged to obtain the packaged chip 100. In some other packaging manners, a package substrate needs to be designed in the packaged chip 100, and the wafer 110 is packaged with assistance of the package substrate to obtain the packaged chip 100. The following uses several related packaging technologies as examples to describe designs of the external metal connection structure.

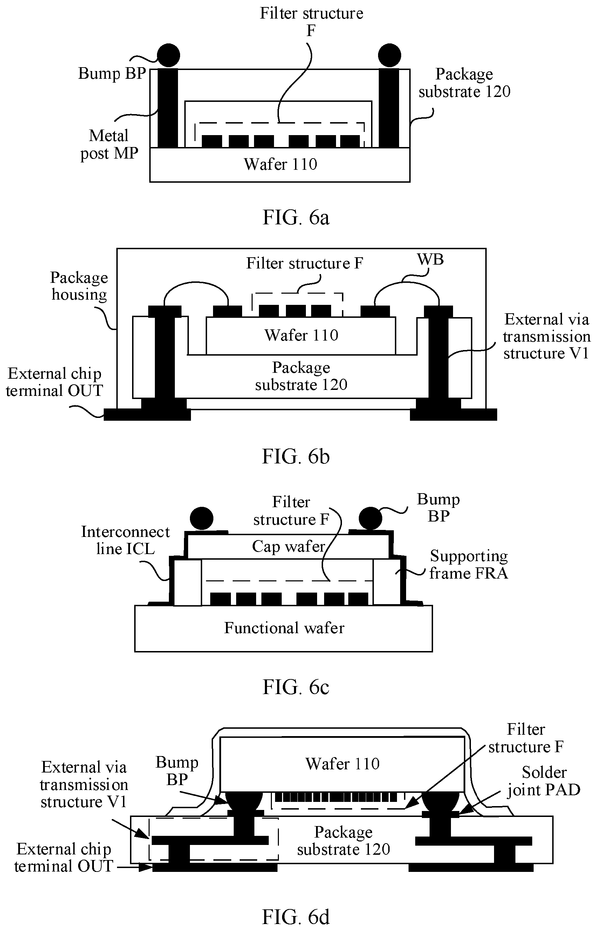

Packaging manner example 1: The filter structure may be packaged based on wafer-level packaging (wafer-level packaging, WLP). As shown in FIG. 6a, a wafer 110 and a package substrate 120 are designed in a packaged chip 100. The package substrate 120 (or a supporting film) is attached to a first surface of the wafer 110. A cavity structure is formed on an attach surface side between the package substrate 120 and the wafer 110, and a filter structure F is disposed on the first surface of the wafer 110 and is located in the cavity structure. In this case, an external metal connection structure may include a metal post MP and a bump (bump, also referred to as a solder ball) BP. The metal post MP is disposed in the package substrate 120 and is located at a joint between the package substrate 120 and the wafer 110. The bump BP is disposed on an outer surface of the package substrate 120. The metal post MP is separately electrically connected to an external end of the filter structure F and the bump BP, to implement an electrical connection between the external end of the filter structure F and the bump BP. In this way, signal transmission between the external end of the filter structure F and an outside of the packaged chip 100 is implemented.

Packaging manner example 2: The filter structure may be packaged based on a surface mount device (surface mount device, SMD) packaging technology. As shown in FIG. 6b, a package substrate 120 and a wafer 110 are packaged and disposed in a package housing. A cavity structure is processed and disposed on the package substrate 120, and the wafer 110 is disposed on the package substrate 120 and located in the cavity structure. A filter structure F is disposed on an upper surface of the wafer 110. In this case, an external metal connection structure may include an external via (via) transmission structure V1 and a metal jumper (wire bonding) WB. The external via transmission structure V1 is a through hole, and passes through the package substrate 120. An external end of the filter structure F located on a first surface side of the package substrate 120 is electrically connected to a first end of the external via transmission structure V1 through the metal jumper WB. A second end of the external via transmission structure V1 forms, from a second surface of the package substrate 120, an electrical connection to an external chip terminal OUT located outside of the package housing.

Packaging manner example 3: The filter structure may be packaged based on a die-sized surface acoustic wave packaging (die-sized SAW packaging, DSSP) technology. As shown in FIG. 6c, a wafer 110 in a packaged chip 100 includes a cap wafer (cap wafer), a functional wafer (functional wafer, also referred to as a bottom functional), and supporting frames (frame) FRA. The cap wafer and the functional wafer are attached based on the supporting frames, to form a cavity structure on an attach surface. A filter structure F may be disposed in the cavity structure. In this case, an external metal connection structure may include an interconnect line (interconnect line) ICL, a bump BP, and the like. An external end of the filter structure F implements an external electrical connection through the supporting frame FRA, the interconnect line ICL, and the bump BP. FIG. 6c shows an example in which the filter structure F is disposed in the cavity structure and located on the functional wafer. Although not shown in the figure, the filter structure may alternatively be disposed in the cavity structure and located on the cap wafer. In addition, although not shown in the figure, an external via transmission structure (for example, a through hole) may be designed in the cap wafer, and the filter structure (which may be disposed on the cap wafer and/or the functional wafer) in the cavity structure is connected to the bump BP through the external via transmission structure.

Packaging manner example 4: The filter structure may be packaged based on a chip scale package (chip scale package, CSP) technology. As shown in FIG. 6d, a wafer 110 is disposed with a filter structure F. An external metal connection structure may include a bump BP, a solder joint PAD, and an external via transmission structure V1. The bump BP is disposed on the wafer 110 (the bump BP may be located on a same surface as the filter structure F or at a position different from that of the filter structure F). An external end of the filter structure F is electrically connected to the bump BP. The solder joint is disposed on a package substrate 120, and the wafer 110 is attached to the solder joint PAD through the bump BP, to implement attachment to the package substrate 120. The solder joint PAD is electrically connected to a first end of the external via transmission structure V1 in the package substrate 120. A second end of the external via transmission structure V1 is electrically connected to an external chip terminal OUT of a packaged chip 100, so that the external end of the filter structure F implements external signal transmission through the external chip terminal OUT.

The foregoing several packaging manners are merely examples for description. In actual practice, more packaging manners may be used to implement designs of the external metal connection structure. Details are not described herein in embodiments of this application.

In a design of the filter structure, design performance of the filter structure may be measured and evaluated based on electrical performance parameters such as insertion loss (insertion loss, IL) of signal transmission and filtering rejection on an out-of-band signal. In addition, for a multiplexer component, for example, a duplexer, signal isolation (isolation) may be further added as an evaluation indicator, for example, isolation between receiving and sending. The insertion loss refers to energy loss of a signal from an input port to an output port within a passband frequency range of the filter structure. The rejection refers to signal energy leaked from an input port to an output port within a stopband frequency range of the filter structure. As shown in FIG. 3c, the isolation refers to signal energy of a receive signal and a transmit signal that is leaked between a receive path and a transmit path. Generally, the insertion loss, the rejection, and the isolation may all be expressed in dB.

In an existing design of a semiconductor acoustic wave filter component, regardless of a packaging manner (for example, the several packaging manners provided in FIG. 6a to FIG. 6d) to be used, a problem of spatial leakage caused by the semiconductor component cannot be avoided. Spatial leakage refers to a phenomenon that when a signal is transmitted in a semiconductor acoustic wave filter, some signal energy is scattered, absorbed, or leaked to an ambient environment due to a material characteristic, a structure limitation, or the like, resulting in a decrease in a filtering capability. There are many reasons that may cause spatial leakage on the filter component, for example, spatial leakage in the wafer 110, spatial leakage in a cavity structure in the semiconductor component, or package leakage caused by a packaging structure. Due to an extremely small size of the semiconductor acoustic wave filter component, the problem of spatial leakage existing on a finished product cannot be completely avoided in technical implementation. However, the problem of spatial leakage may cause deterioration in isolation and rejection of the filter component, affecting performance of the filter component. In addition, in some scenarios requiring high isolation, if a leakage amplitude of spatial leakage is greater than an isolation requirement, the filter component may even fail to meet an actual application requirement.

To improve the performance of the filter component (for example, improve rejection and isolation), optimization is performed in a related technology mainly from two aspects: one is to reduce as much as possible deterioration in rejection and isolation caused by spatial leakage; and the other is to increase rejection and isolation.

In terms of reducing deterioration in rejection and isolation caused by spatial leakage, main manners are: designing a metal package surface layer to reduce spatial leakage, dividing the filter structure F into a plurality of dies (die) to reduce spatial leakage on a single die, and the like. However, such manners increase a chip processing process, resulting in a significant increase in manufacturing costs. In addition, these manners cannot completely avoid all spatial leakage, and have limited improvement effects.

In terms of increasing rejection and isolation, the following manners are mainly used.

Manner 1: Increase an order of a filter resonant structure, that is, increase a quantity of resonators X in the filter resonant structure shown in FIG. 3. However, this application manner has a limitation of an area overhead of a single packaged chip 100 and some other limitations, and there is a distinct upper limit on the quantity of resonators X. In addition, although this manner can improve rejection of the filter component, the insertion loss is increased. In addition, as spatial leakage always exists, an effect of improving rejection is limited.

Manner 2: Cascade a plurality of filter chips. However, this manner does not improve a chip, but only brings benefits based on an increase in a quantity. This manner increases costs and increases the insertion loss.

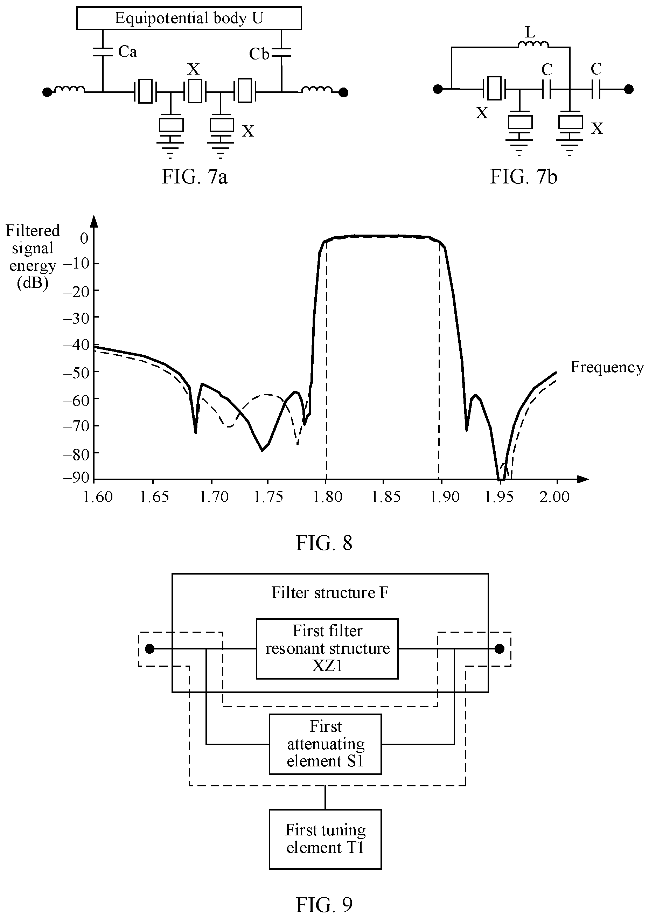

Manner 3: Add a transmission zero of the filter component. For example, a zero-point cavity is designed in the packaged chip 100, and the transmission zero is added by using the zero-point cavity. The transmission zero added by using the zero-point cavity usually has a shallow depth, having a limited effect of improving rejection and isolation. In addition, the manner of adding the zero-point cavity also increases the insertion loss of the filter component. For another example, as shown in FIG. 7a, a capacitor Ca, an equipotential body U, and a capacitor Cb that are connected in series may be designed. The capacitor Ca, the equipotential body U, and the capacitor Cb are connected in parallel to a filter structure F to form a special resonant structure, so as to improve out-of-band rejection of a filter component. For example, the structure shown in FIG. 7a is used for a transmit structure of a duplexer, and frequency-rejection response relationships of the transmit structure are shown in FIG. 8. A dashed curve in FIG. 8 shows a curve change of a frequency-rejection response relationship when the structure shown in FIG. 7a is used for the transmit structure of the duplexer, and a solid line in FIG. 8 shows a curve change of a frequency-rejection response relationship when the structure shown in FIG. 7a is not used for the transmit structure of the duplexer. A frequency range within two dashed vertical lines is a passband frequency range of the transmit structure. For the transmit structure, a filter function needs to be implemented within the passband frequency range, and a signal filter rejection function needs to be implemented within a stopband frequency range. Based on different actual practice and designs, a filter component (for example, the duplexer) may operate in different frequency bands. For example, the duplexer operates in a B3 frequency band (a receive frequency range is 1,710 MHz to 1,785 MHz, and a transmit frequency range is 1,805 MHz to 1,880 MHz). It can be learned from FIG. 8 that, for the transmit structure, the filter function needs to be implemented within the transmit frequency range of 1,805 MHz to 1,880 MHz, and rejection is required in the receive frequency range of 1,710 MHz to 1,785 MHz within the stopband frequency range of the transmit structure. It can be learned that this method can only improve rejection within a small frequency range (for example, a small range of about 1.749 GHz), having a limited effect as using a zero-point cavity. In addition, this implementation further causes rejection deterioration at some frequency positions at which rejection needs to be improved, for example, rejection at frequency positions of 1.71 GHz and 1.785 GHz is reduced. For another example, as shown in FIG. 7b, a plurality of capacitors C may be connected in series on a serial path of a filter structure F, and an inductor L may be connected in parallel to the filter structure F. Resonance is formed based on the inductor L and the plurality of capacitors C connected in series, to generate an additional transmission zero, so as to improve rejection and isolation. However, the solution in FIG. 7b is difficult to be implemented in actual practice. To achieve a good effect, the solution usually requires an inductor component on an order of uH, which is usually very large in size and is difficult to be integrated inside a chip. Even if some very complex processing design manners are used for integration, area overheads of a final chip product are still very large, and it is difficult to implement miniaturization practice. In addition, if the solution is implemented in a form of a separate component (for example, a lumped inductor), there may be great effect loss and difference between an actual improvement effect of the solution and an ideal effect of circuit simulation.

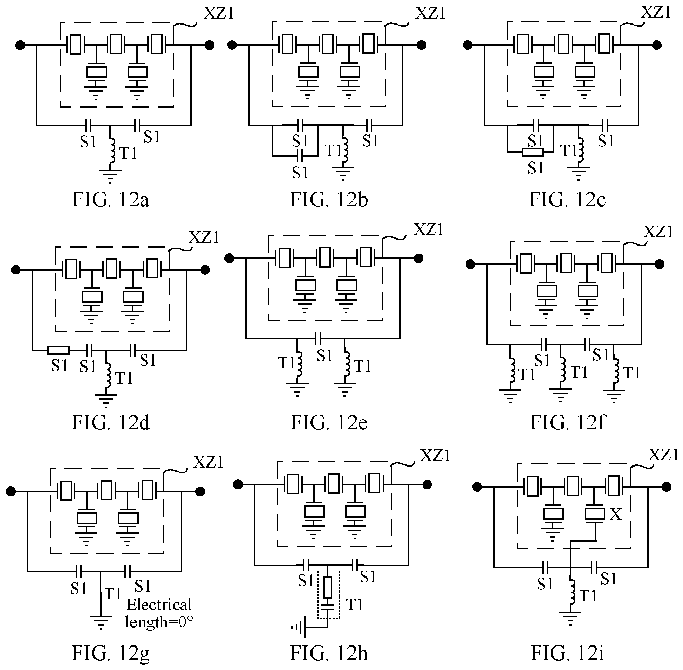

To reduce the problem of spatial leakage of the filter component, and improve performance of the filter component, based on an improvement idea of adding the transmission zero, embodiments of this application propose to construct a coupling path connecting an input end and an output end of a filter resonant structure that needs to be optimized in a filter structure, to improve performance of the corresponding filter resonant structure by using the coupling path. For example, filter performance optimization is performed on a first filter resonant structure in the filter structure. The coupling path includes at least one first attenuating element and at least one first tuning element. As shown in FIG. 9, a first filter resonant structure XZ1 and each first attenuating element S1 of at least one first attenuating element S1 form a parallel structure, a first end of each first tuning element T1 of at least one first tuning element T1 is connected to a transmission path formed by a first end and a second end of the first filter resonant structure XZ1 and the at least one first attenuating element S1, and a second end of each first tuning element T1 is grounded. The first attenuating element S1 may be an equivalent capacitor or an equivalent resistor. The first tuning element T1 may be an equivalent inductor, an equivalent capacitor, or an equivalent resistor. When the at least one first attenuating element S1 includes a plurality of first attenuating elements S1, the plurality of first attenuating elements S1 may be connected in different manners (for example, in parallel, in series, or in series and parallel). Similarly, when the at least one first tuning element T1 includes a plurality of first tuning elements T1, each first tuning element T1 may be disposed at any position on the transmission path. For examples of connection relationships when the plurality of first attenuating elements S1 or first tuning elements T1 in FIG. 9 are disposed, refer to related descriptions in the following embodiments of FIG. 12a to FIG. 12i.

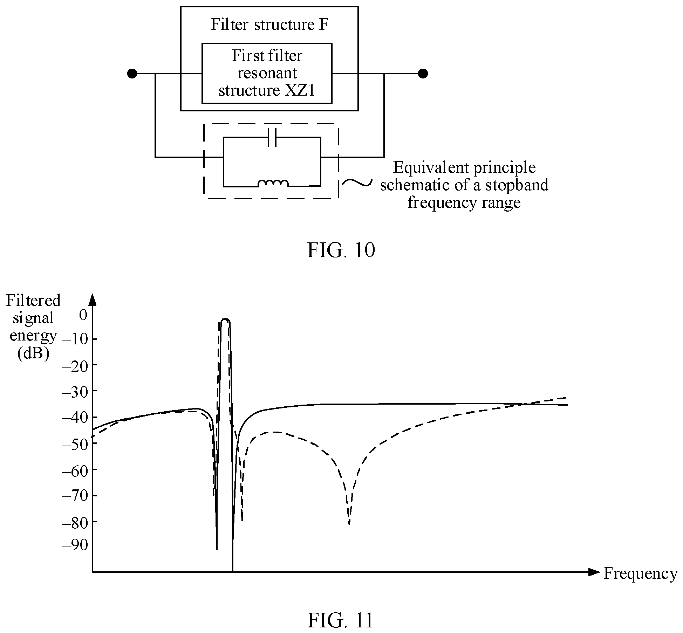

In embodiments of this application, an example in which the coupling path structure shown in FIG. 9 is used in a filter structure F is used. When the filter structure F operates, for a radio frequency signal outside of a passband frequency range (that is, within a stopband frequency range), spatial leakage at the coupling path, the first filter resonant structure XZ1, and a position of the first filter resonant structure XZ1 (that is, spatial leakage at a semiconductor structure in which the first filter resonant structure XZ1 is located) is equivalent to a resonant circuit connected in parallel to the first filter resonant structure XZ1. A specific equivalent principle schematic is shown in FIG. 10. For the radio frequency signal within the stopband frequency range, a resonant circuit structure equivalent to the coupling path is presented as an open circuit, and a transmission zero may be generated. In this process, the at least one first attenuating element S1 may attenuate an out-of-band signal, and a parameter value of the transmission zero may be adjusted by adjusting a design of the at least one first tuning element T1. FIG. 11 is a diagram of a filtering effect of a filter structure F based on the structure shown in FIG. 9. In FIG. 11, a horizontal coordinate represents a frequency range, a vertical coordinate represents filtered signal energy (unit: dB), a solid line is a frequency-signal energy change curve when the coupling path is not used, and a dashed line is a frequency-signal energy change curve of a filtered signal when the coupling path is used. A bandpass frequency range of the filter structure F is shown as between two vertical dashed lines, and other parts are stopband frequency ranges of the filter structure F. It can be learned that after the coupling path is designed, a resonant transmission zero is generated within the stopband frequency range at a circle, thereby greatly improving rejection and isolation of an out-of-band signal. In addition, the coupling path constructed based on the first attenuating element S1 and the first tuning element T1 in this solution does not increase signal insertion loss of the original filter structure.

In conclusion, the solution of constructing the coupling path by using the first attenuating element S1 and the first tuning element T1 has the following advantages: Advantage 1: Compared with a transmission zero added by using a zero-point cavity, an equipotential body, or the like, the added transmission zero has a larger depth, and has higher rejection and isolation. Advantage 2: This solution does not significantly increase the signal insertion loss, while the foregoing solution has limited rejection and isolation improvement and further deteriorates the signal insertion loss. Advantage 3: Although an equivalent inductor is used on the coupling path, the coupling path has a low requirement on an inductance value of the inductor, and it is easy to implement an integrated miniaturization design of a component. In addition, both the first tuning element T1 and/or the first attenuating element S1 on the coupling path can be manufactured based on a mature manufacturing process of a semiconductor filter structure, and the first tuning element T1 and/or the first attenuating element S1 can be integrated into a semiconductor component without adding a new process.

In some possible implementations, when the at least one first attenuating element S1 includes a plurality of first attenuating elements S1, the plurality of first attenuating elements S1 are connected in series and/or in parallel. For example, the first attenuating element S1 is an equivalent capacitor, and the first tuning element T1 is an equivalent inductor. In an example, as shown in FIG. 12a, alternatively, two first attenuating elements S1 may be connected in parallel between a first end and a second end of a first filter resonant structure XZ1, and the two first attenuating elements S1 are connected in series. In an example, as shown in FIG. 12b, alternatively, two first attenuating elements S1 as equivalent capacitors may be connected in parallel, and then connected in series to one first attenuating element S1 as an equivalent capacitor.

For example, the plurality of first attenuating elements S1 include a first attenuating element S1 as an equivalent capacitor and a first attenuating element S1 as an equivalent resistor, and the first tuning element T1 is an equivalent inductor. In an example, as shown in FIG. 12c, one first attenuating element S1 as an equivalent capacitor and one first attenuating element S1 as an equivalent resistor are connected in parallel, and then connected in series to one first attenuating element S1 as an equivalent capacitor C. In an example, as shown in FIG. 12d, one first attenuating element S1 as an equivalent resistor is connected in series to two first attenuating elements S1 as equivalent capacitors. In FIG. 12a, FIG. 12b, FIG. 12c, and FIG. 12d, the first attenuating elements S1 and the first filter resonant structure XZ1 form a parallel structure.

For example, one first tuning element T1 is short-circuited on a transmission path formed by the plurality of first attenuating elements S1. The foregoing is merely an example for description. During an actual design, a quantity of first tuning elements T1 and a quantity of first attenuating elements S1 are not limited, and more first tuning elements T1 may be short-circuited on the transmission path formed by the plurality of first attenuating elements S1. For example, in FIG. 12e, only one first attenuating element S1 may be designed while two first tuning elements T1 may be designed. In FIG. 12f, a plurality of first attenuating elements S1 may be designed while a plurality of first tuning elements T1 may be designed.

For example, in the foregoing example figures, an example in which the first tuning element T1 is an equivalent inductor is used for description. Alternatively, the first tuning element T1 may be of another structure. In an example, as shown in FIG. 12g, a short-circuited transmission line (for example, a short-circuited transmission line whose electrical length is 0°) may be equivalent to an inductor and used as the first tuning element T1. In an example, as shown in FIG. 12h, the first tuning element T1 may be based on an equivalent resistor and an equivalent capacitor.

In some possible implementations, in some application scenarios, as shown in FIG. 12i, some resonators X in a ladder structure are designed to be grounded after being connected to an inductor. In this case, these resonators X that need to be connected to the inductor may be designed to be connected to the first tuning element T1 that is used as the equivalent inductor.

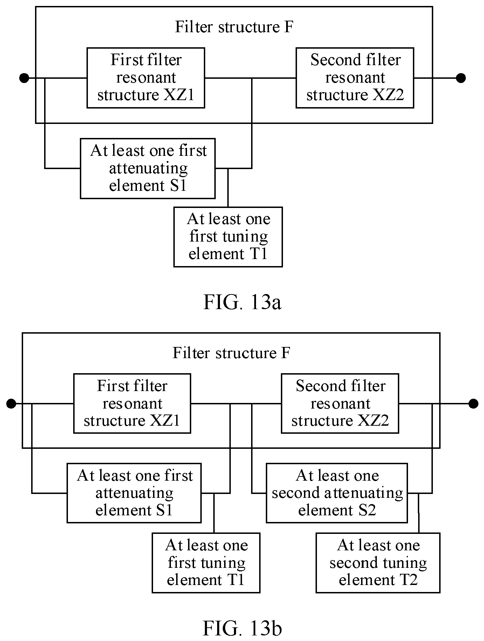

In some possible implementations, as shown in FIG. 13a, a filter structure F may further include a second filter resonant structure XZ2, and a first end of the second filter resonant structure XZ2 is connected to a second end of a first filter resonant structure XZ1. In the foregoing embodiment of this application, when the filter structure F includes only the first filter resonant structure XZ1, a parallel coupling path is designed for the filter structure F as a whole to implement a design of a transmission zero. However, in the embodiment shown in FIG. 13a of this application, the filter structure F may include a plurality of filter resonant structures, and the coupling path may be connected in parallel to only some filter resonant structures in the filter structure F.

In some possible implementations, as shown in FIG. 13b, a packaged chip 100 further includes at least one second attenuating element S2 and at least one second tuning element T2. The second attenuating element S2 is an equivalent capacitor or an equivalent resistor. The second tuning element T2 is an equivalent capacitor, an equivalent inductor, or an equivalent resistor. The at least one second attenuating element S2 is connected to the first end and a second end of the second filter resonant structure XZ2, to form a parallel structure with the second filter resonant structure XZ2. A first end of each second tuning element T2 is connected to a transmission path formed by the first end and the second end of the second filter resonant structure XZ2 and the at least one second attenuating element S2, and a second end of each second tuning element T2 is grounded. In the embodiment shown in FIG. 13b of this application, a filter structure F includes a plurality of filter resonant structures, and corresponding coupling paths may be respectively designed for different filter resonant structure parts. For a specific technical principle and beneficial effects of forming a coupling path by using the second attenuating element S2 and the second tuning element T2, refer to related descriptions of the foregoing first attenuating element S1 and the foregoing first tuning element T1. Details are not described herein again.

In some possible implementations, the filter structure may be based on a ladder structure, or may be based on a structure of a ladder combined with a DMS, or may be based on a DMSstructure. For example, the ladder structure may be based on acoustic wave resonators, or may be based on a combination of an acoustic wave resonator and a capacitor (replacing a part of resonators), or may be based on a combination of an acoustic wave resonator and an electromagnetic resonator (electromagnetic resonator).

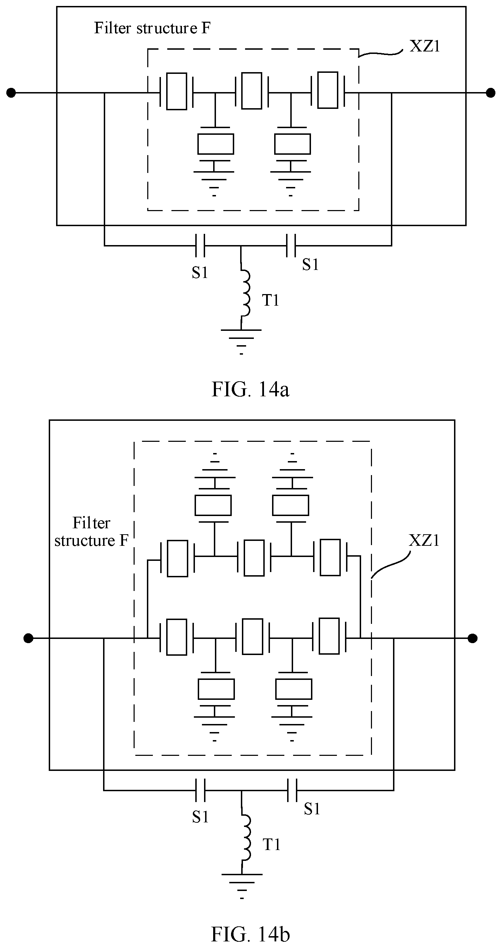

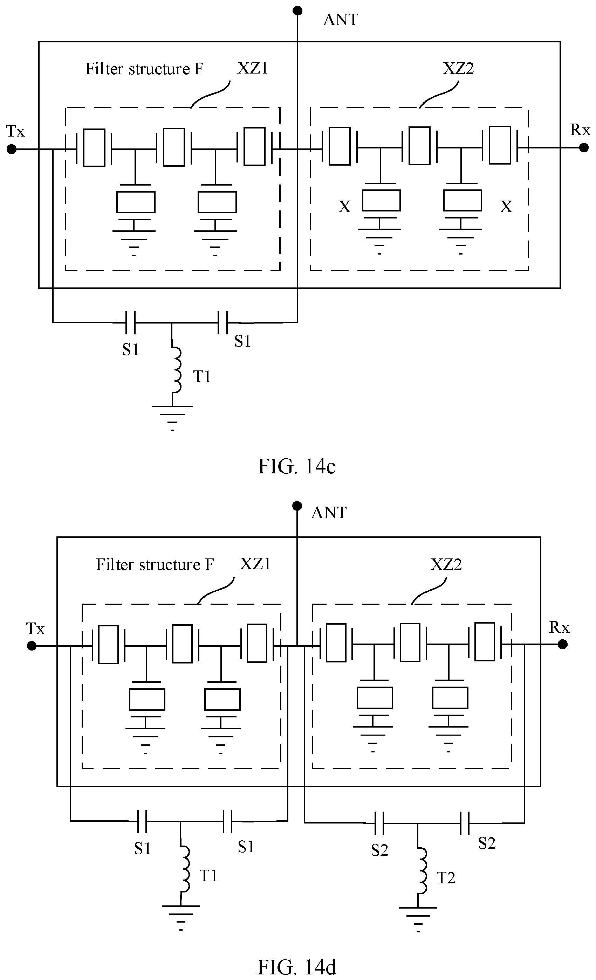

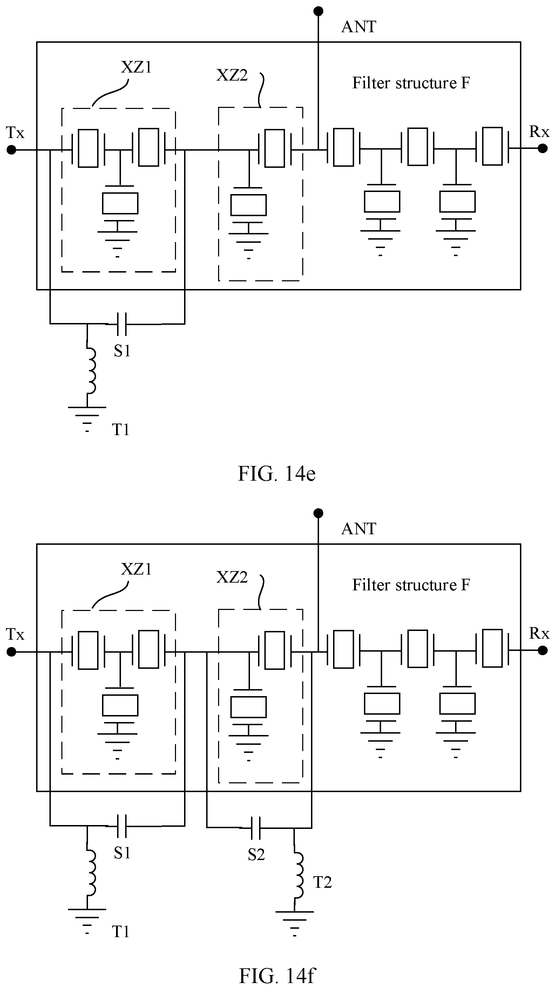

For example, the filter structure may be based on a ladder structure, and the ladder structure is based on acoustic wave resonators. In an example, as shown in FIG. 14a, a filter structure F includes a first filter resonant structure XZ1 as a 5-order filter resonant structure, and a coupling path formed by a first tuning element T1 and first attenuating elements S1 is connected in parallel to two ends of the filter structure F. In an example, as shown in FIG. 14b, a filter structure F includes a first filter resonant structure XZ1, and the first filter resonant structure XZ1 is a dual-passband filter structure including two 5-order filter resonant structures. A coupling path formed by a first tuning element T1 and first attenuating elements S1 is connected in parallel to two ends of the filter structure F. In an example, as shown in FIG. 14c and FIG. 14d, a filter structure F is a duplexer, and a first filter resonant structure XZ1 may be a corresponding filter resonant structure at a transmit end Tx of the duplexer. Similarly, a second filter resonant structure XZ2 may be a corresponding filter resonant structure at a receive end Rx of the duplexer. In FIG. 14c, a corresponding coupling path may not be designed at the second filter resonant structure XZ2. In FIG. 14d, a coupling path based on a second tuning element T2 and second attenuating elements S2 may alternatively be designed at the second filter resonant structure XZ2. In an example, as shown in FIG. 14e and FIG. 14f, a filter structure F is a duplexer, and a first filter resonant structure XZ1 and a second filter resonant structure XZ2 may be separately a part of a corresponding filter resonant structure at a transmit end Tx of the duplexer. In FIG. 14e, a corresponding coupling path may not be designed at the second filter resonant structure XZ2. In FIG. 14f, a coupling path based on a second tuning element T2 and a second attenuating element S2 may alternatively be designed at the second filter resonant structure XZ2.

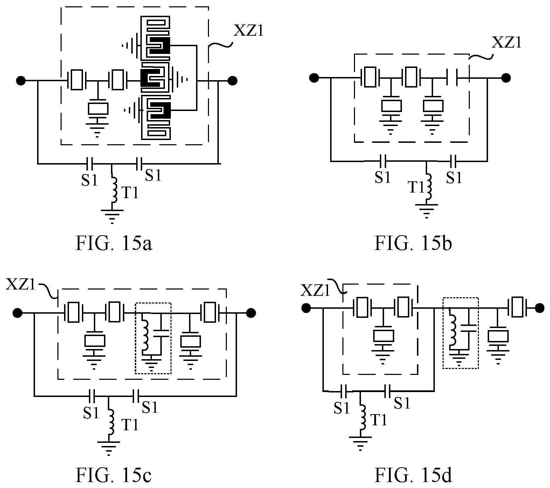

For example, as shown in FIG. 15a, a first filter resonant structure XZ1 of a filter structure F may be based on a ladder structure and a DMS structure. For example, as shown in FIG. 15b, a first filter resonant structure XZ1 of a filter structure F may be based on a ladder structure, and the first filter resonant structure XZ1 is a filter resonant structure based on a combination of acoustic wave resonators and a capacitor. For example, as shown in FIG. 15c, a filter structure may be based on a ladder structure, and a first filter resonant structure XZ1 in the ladder structure is a filter resonant structure based on a combination of acoustic wave resonators and an electromagnetic resonator. For example, as shown in FIG. 15d, a filter structure may be based on a ladder structure, and the ladder structure of the filter structure F is a filter resonant structure based on a combination of acoustic wave resonators and an electromagnetic resonator. A first filter resonant structure XZ1 in FIG. 15d may be a filter resonant structure part based on acoustic wave resonators.

The foregoing embodiments in FIG. 14 and FIG. 15 are merely several examples of designs of the filter structure F. In actual practice, an adaptive transformation design may be performed based on the foregoing example ideas and other design ideas that are not exhaustively listed.

In some possible implementations, an equivalent capacitor and/or an equivalent resistor may be designed as an attenuating element and/or a tuning element based on different manners. For example, an interdigital capacitor, a plate capacitor, an equivalent capacitor of parallel conduct wires, or a lumped capacitor is used as the equivalent capacitor. Similarly, a structure with a specific resistance may be designed as the equivalent resistor.

In some possible implementations, an equivalent inductor used as the tuning element may be designed based on different manners. For example, a winding coil, a short-circuited transmission line, a via, or a lumped inductor is used as the equivalent inductor.

In some possible implementations, based on different packaging technologies and different design requirements, a coupling path may be designed at different positions on a radio frequency communication module 1000 or a packaged chip 100. It can be learned from the foregoing principle descriptions that the coupling path can implement tuning with a filter resonant structure, in the filter structure F, that is connected in parallel to the coupling path and tuning with a spatial leakage structure at a position of the coupling path, to improve rejection. Therefore, an adaptive design may be selected based on selection of product design parameters, different application scenarios, different package structures, and the like. The following uses several common package structure types as examples for description.

Example 1: At least one first attenuating element S1 and/or at least one first tuning element T1 are/is formed on a wafer 110. In this case, each first attenuating element S1 and the filter structure F are located on a same surface or different surfaces of the wafer 110, and each first tuning element T1 and the filter structure F are located on a same surface or different surfaces of the wafer 110. In this embodiment of this application, the filter structure F may be designed on the wafer 110. Based on different designs, the filter structure F and an element on a coupling path may be located on a same structural surface, or may be located on different structural surfaces. For example, the wafer-level packaging shown in FIG. 6a is used as an example. The filter structure F is disposed in a cavity structure of the wafer 110, some or all elements (for example, an attenuating element and/or a tuning element) on the coupling path may be designed in the wafer 110, and different elements may be disposed on a same surface or different surfaces as the filter structure F. The first attenuating element S1 and the first tuning element T1 may implement electrical connections to the filter structure F based on a metal connection structure. The metal connection structure may be a structure, for example, a via, a metal transmission line, a bump, or a solder pad.

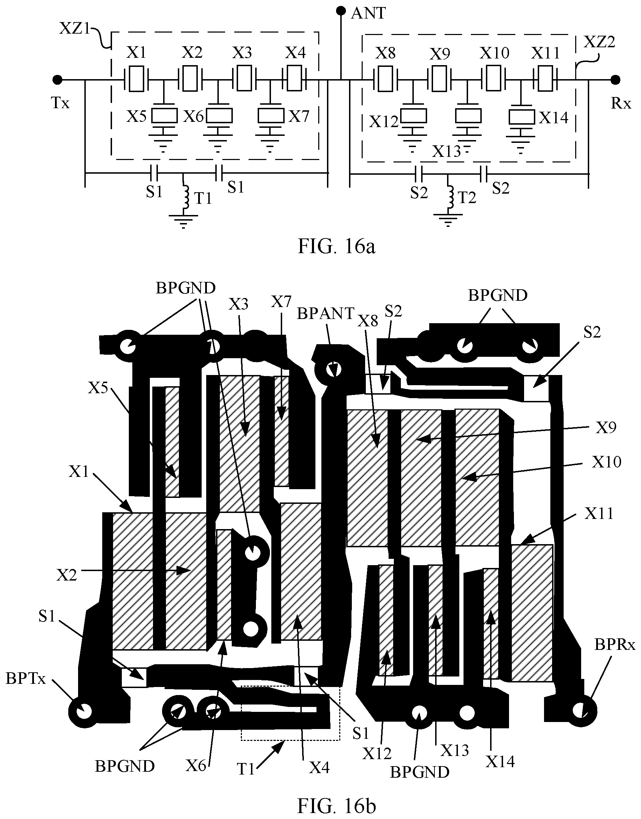

For example, as shown in FIG. 16a and FIG. 16b, FIG. 16a is a circuit principle schematic of a duplexer having a coupling path. The duplexer includes a 7-order resonance filter structure (that is, a first filter resonant structure XZ1) on a side of a transmit end Tx and a 7-order resonance filter structure (that is, a second filter resonant structure XZ2) on a side of a receive end Rx. FIG. 16b is a diagram of a design structure of a wafer designed based on the principle schematic of FIG. 16a. In the figure, a resonator X1, a resonator X2, a resonator X3, and a resonator X4 in the first filter resonant structure XZ1 are connected to a resonator X5, a resonator X6, and a resonator X7 through metal lines, and a first end of the resonator X1 is used as an external end of the transmit end Tx related to the filter structure. A resonator X8, a resonator X9, a resonator X10, and a resonator X11 in the second filter resonant structure XZ2 are connected to a resonator X12, a resonator X13, and a resonator X14 through metal lines. An external end is led out from a joint between a second end of the resonator X4 and a first end of the resonator X8 as an external end connecting the duplexer and an antenna ANT. The first end of the resonator X1 is used as an external end connecting the duplexer and a transmit end Tx of a radio frequency transmit channel A220. A second end of the resonator X11 is used as an external end connecting the duplexer and a receive end Rx of a radio frequency receive channel A210. Two first attenuating elements S1 (for example, interdigital capacitors as equivalent capacitors) are connected in parallel between a first end and a second end (that is, between an external end of the Tx and an external end of the ANT) of the first filter resonant structure XZ1. A metal coil is designed on the wafer 110 to form an equivalent inductor, and is used as a first tuning element T1. Similarly, two second attenuating elements S2 (for example, interdigital capacitors as equivalent capacitors) may be connected in parallel between a first end and a second end (that is, between an external end of the Rx and the external end of the ANT) of the second filter resonant structure XZ2. A metal coil is designed on the wafer 110 to form an equivalent inductor, and is used as a second tuning element T2.

In an example, in an application scenario shown in FIG. 16b, an external metal connection structure may be designed on a packaged chip 100, to implement an electrical connection between a filter structure F and an outside of the packaged chip 100. An example in which the filter structure F is packaged based on the chip scale package (chip scale package, CSP) technology shown in FIG. 6d is used. As shown in FIG. 16b, the external metal connection structure may include a bump BPRx, a bump BPTx, a bump BPANT, and a bump BPGND. The bump BPRx corresponds to an external metal connection structure, on the wafer 110, of the external end of the receive end Rx. The bump BPTx corresponds to an external metal connection structure, on the wafer 110, of the external end of the transmit end Tx. The bump BPANT corresponds to an external metal connection structure, on the wafer 110, of the external end of the antenna ANT. The bump BPGND corresponds to an external metal connection structure of a connection end, in the filter structure F, that is used to be grounded. For specific principles and specific structures for implementing electrical connections between the bump BPRx, the bump BPTx, the bump BPANT, and the bump BPGND on the wafer 110 and a package substrate 120, refer to related descriptions of the external metal connection structure in FIG. 6d. Details are not described herein again. In addition, although not shown in FIG. 16b, a design of the external metal connection structure may alternatively be implemented based on another packaging technology. For other designs of the external metal connection structure, refer to the descriptions in embodiments in FIG. 6a to FIG. 6d. Details are not described herein again.

Example 2: For a packaged chip 100 including a package substrate 120, an attenuating element and/or a tuning element on a coupling path may be partially or entirely designed on the package substrate 120. In this case, for the attenuating element and/or the tuning element designed on the package substrate 120, a metal connection structure needs to be designed, so that the attenuating element and/or the tuning element on the package substrate 120 are/is electrically connected to a filter structure F on a wafer 110, to form a transmission path of the coupling path. For example, at least one first attenuating element S1 and/or at least one first tuning element T1 in a first filter resonant structure XZ1 may be formed on the package substrate 120. In this case, the metal connection structure is connected to a first end of the first filter resonant structure XZ1, the at least one first attenuating element S1, and a second end of the first filter resonant structure XZ1, to form a transmission path connecting the first end of the first filter resonant structure XZ1, the at least one first attenuating element S1, and the second end of the first filter resonant structure XZ1. The metal connection structure is further connected to a first end of at least one first tuning element T1, so that the first end of each first tuning element T1 is connected to the transmission path formed by the first end and the second end of the first filter resonant structure XZ1 and the at least one first attenuating element S1. In this embodiment of this application, a function of the metal connection structure is to implement an electrical connection between elements on the package substrate 120 and the filter structure on the wafer 110, so that the elements at different positions can normally form the coupling path. Different metal connection structures may be designed by using different packaging technologies. A design of the metal connection structure is not limited in this embodiment of this application. The following uses an example in which the tuning element is designed on the package substrate for description.

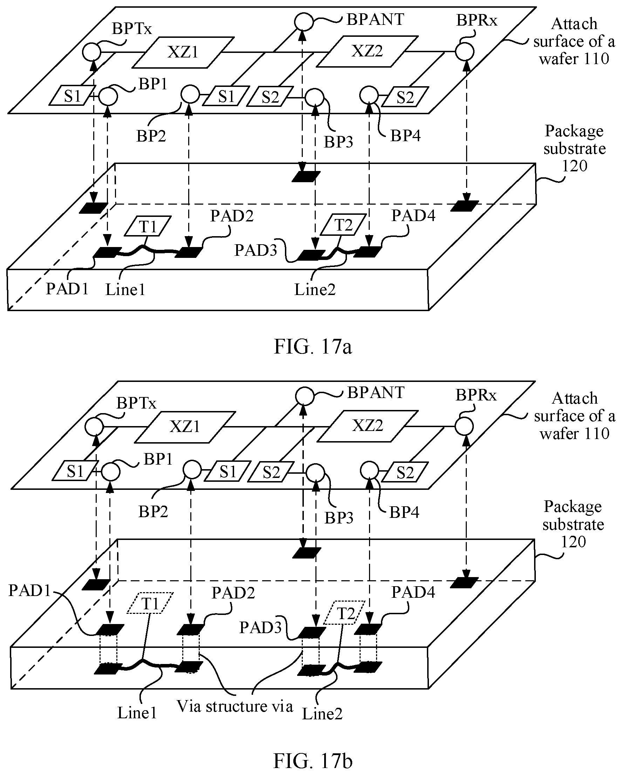

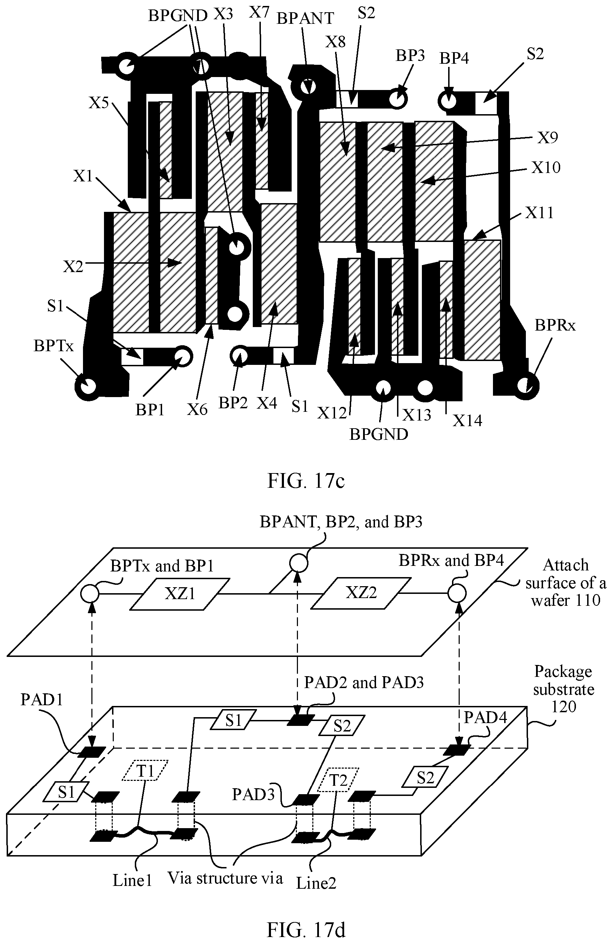

For example, the at least one first tuning element T1 may be formed on the package substrate 120 based on the chip scale package (chip scale package, CSP) technology shown in FIG. 6d. In this case, the metal connection structure includes a first bump, a second bump, a first solder joint, a second solder joint, and a first metal line. The first bump and the second bump are disposed on the wafer 110. The first solder joint and the second solder joint are disposed on a first surface of the package substrate 120. The first bump is connected to the first end of the first filter resonant structure XZ1, and the second bump is connected to the second end of the first filter resonant structure XZ1. The first bump is bonded to the first solder joint, and the second bump is bonded to the second solder joint. The first solder joint is connected to the second solder joint through the first metal line, to form a transmission path connecting the first end of the first filter resonant structure XZ1, the first bump, the second bump, the second end of the first filter resonant structure XZ1, and the at least one first attenuating element S1. The first end of each first tuning element T1 is electrically connected to the first metal line, and the second end of the first tuning element T1 is grounded. In an example, the first tuning element T1 may be designed to be located on a surface, of the package substrate 120, the same as the first solder joint and the second solder joint, that is, the first tuning element T1 is located on a surface, attached to the wafer 110, that is of the package substrate 120. In this case, for example, the filter structure F is the filter structure of the duplexer shown in FIG. 16a, the first filter resonant structure XZ1 on the wafer 110 is a filter resonant structure from the Tx to the ANT, and the second filter resonant structure XZ2 is a filter resonant structure from the ANT to the Rx. The first bump BP1 is connected to the first end (that is, the external end of the Tx that corresponds to the filter resonant structure F) of the first filter resonant structure XZ1, and the second bump BP2 is connected to the second end (that is, the external end of the ANT that corresponds to the filter structure F) of the first filter resonant structure XZ1. As shown in FIG. 17a to FIG. 17d, one first attenuating element S1 is disposed between a first bump BP1 and a first end of a first filter resonant structure XZ1, and the other first attenuating element S1 is disposed between a second bump BP2 and a second end of the first filter resonant structure XZ1. A wafer 110 is attached to a package substrate 120 in a manner that the first bump BP1 is bonded to a first solder joint PAD1 and the second bump BP2 is bonded to a second solder joint PAD2. On an attach surface of the package substrate 120, a first metal line Line1 connects the first solder joint PAD1 to the second solder joint PAD2, to form a transmission path connecting the first end of the first filter resonant structure XZ1, the first bump BP1, the first solder joint PAD1, the first metal line Line1, the second solder joint PAD2, the second bump BP2, the two first attenuating elements S1, and the second end of the first filter resonant structure XZ1. The transmission path and the first filter resonant structure XZ1 form a resonant structure in parallel. In addition, the transmission path further forms resonant tuning with a spatial leakage structure at a position of the transmission path. In this case, a first tuning element T1 may be designed on the package substrate 120, a first end of the first tuning element T1 is connected to the first metal line Line1, and a second end of the first tuning element T1 is grounded. There may be different design manners based on different selections of the first tuning element T1. For example, the first tuning element T1 is an equivalent inductor, and the equivalent inductor is a winding coil or a short-circuited transmission line. As shown in FIG. 17a, the first tuning element T1 as the equivalent inductor may be designed on the attach surface of the package substrate 120 and directly connected to the first metal line Line1, and is grounded through a grounded via structure via on the package substrate 120. As shown in FIG. 17b, the first tuning element T1 as the equivalent inductor may be designed on a non-attach surface of the package substrate 120 and connected to the first metal line Line1 through the via structure via, and is grounded. Although not shown in the figure, the first tuning element T1 may alternatively be designed on an inner side of the package substrate 120. FIG. 17c is an example of a structure on the wafer 110 based on the packaging manners shown in FIG. 17a and FIG. 17b.

In FIG. 17a, FIG. 17b, and FIG. 17c, an example in which the first attenuating element S1 is formed on the wafer 110 is used. In this case, any first attenuating element S1 is connected in series between the first bump and the first end of the first filter resonant structure XZ1, or between the second bump and the second end of the first filter resonant structure XZ1. In another example, as shown in FIG. 17d, when the first tuning element T1 and the two first attenuating elements S1 are all disposed on the package substrate 120, a bump BPTx of a Tx in a packaged chip 100 may be reused as the first bump BP1, a bump BPANT in the packaged chip 100 may be reused as the second bump BP2 and a third bump BP3, and a bump BPRx in the packaged chip 100 may be reused as a fourth bump BP4. In addition, the first attenuating element S1 may be disposed on a transmission path connecting the first solder joint PAD1 corresponding to the first bump BP1 and the second solder joint PAD2 corresponding to the second bump BP2.

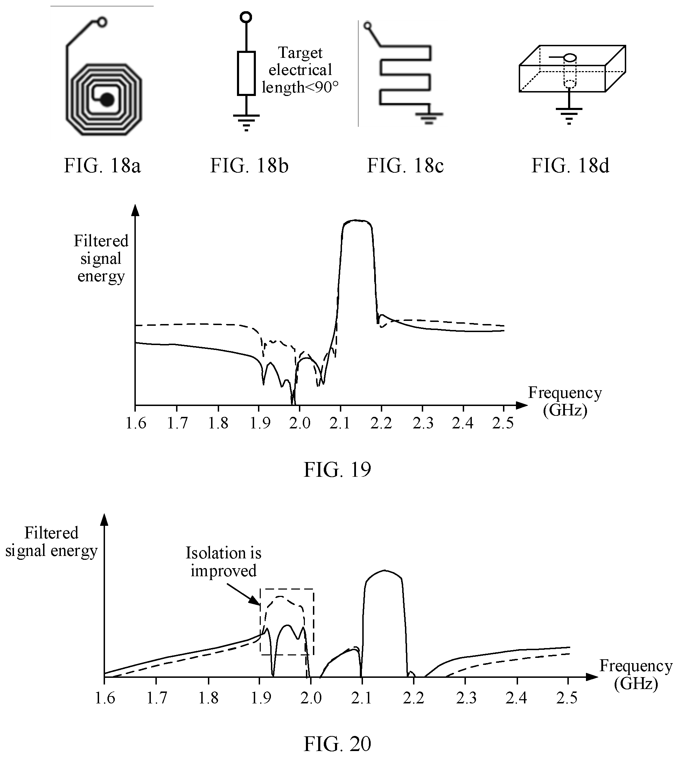

For example, when the tuning element is the equivalent inductor, the tuning element may be a winding coil shown in FIG. 18a, or may be a short-circuited transmission line shown in FIG. 18b, where a target electrical length of the short-circuited transmission line is less than 90°. The target electrical length is an electrical length of the short-circuited transmission line at a lowest cut-off frequency in a corresponding filter passband range. The tuning element may be a lumped inductor shown in FIG. 18c, or may be an inductor equivalent to a via transmission structure shown in FIG. 18d.

In the foregoing embodiment of Example 2, based on the packaging technology shown in FIG. 6d, the metal connection structure implemented by the bump and the solder joint is described. Similarly, the packaging technology in FIG. 6b or FIG. 6a may alternatively be used to design the metal connection structure. When at least one first tuning element T1 is formed on a package substrate 120, the metal connection structure may include a first metal jumper or a metal post. A first end of the at least one first tuning element T1 is connected to a first end of the first metal jumper, and a second end of the first metal jumper is connected to a transmission path formed by a first end and a second end of a first filter resonant structure XZ1 and at least one first attenuating element S1. Alternatively, a first end of the at least one first tuning element T1 is connected to a first end of the metal post, and a second end of the metal post is connected to a transmission path formed by a first end and a second end of a first filter resonant structure XZ1 and at least one first attenuating element S1.

In addition, in some packaging technologies (for example, some packaging technologies shown in FIG. 6a to FIG. 6d), a wafer 110 independently forms a cavity structure, or forms a cavity structure with another structure. A filter structure F may be designed in the cavity structure. When the at least one first tuning element T1 is formed on the package substrate 120, a design of the metal connection structure (for example, a bump, a solder joint, a via, a metal jumper, and a metal post) may also be implemented by using various packaging technologies described in the foregoing embodiments.

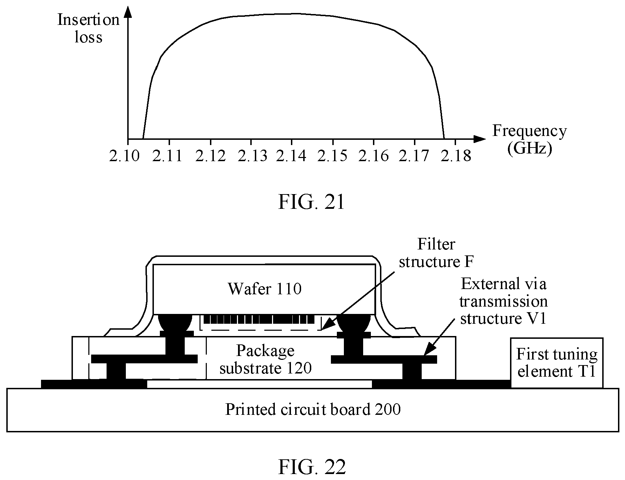

For specific technical principles and beneficial effects of disposing the first attenuating element S1, the second attenuating element S2, and the second tuning element T2 on package substrate 120, refer to the descriptions of the foregoing related embodiments of the external metal connection structure and the metal connection structure design related to the first tuning element T1. Details are not described herein again. FIG. 19 is a diagram of a signal rejection effect after a coupling path is designed for the first filter resonant structure XZ1 or the second filter resonant structure XZ2 (that is, the filter resonant structure between the ANT and the Rx or the filter resonant structure between the Tx and the ANT in the duplexer) in the duplexer shown in FIG. 17. A dashed line in FIG. 19 is a frequency-filtered signal strength change curve when the coupling path is not designed, and a solid line in FIG. 19 is a frequency-filtered signal strength change curve when the coupling path is designed. It can be learned that filtered signal strength of an out-of-band signal is distinctly reduced. In the duplexer, a receive and transmit isolation design needs to be performed between receiving and transmitting. For example, a coupling path is designed for a filter structure between the transmit end Tx and the antenna ANT. FIG. 20 shows frequency-filtered signal strength change curves. A dashed line in FIG. 20 is a frequency-filtered signal strength change curve when the coupling path is not designed, and a solid line in FIG. 20 is a frequency-filtered signal strength change curve when the coupling path is designed. It can be learned that signal isolation of a transmit signal within an out-of-band frequency range is greatly improved. FIG. 21 is a diagram of a change of insertion loss with a frequency within a passband frequency range before and after a coupling path is designed. In this case, insertion loss changes in two cases are similar, and frequency-insertion loss change curves are consistent. It can be learned that after the coupling path is designed, the signal insertion loss is not increased.

For example, when a short-circuited transmission line is used in a packaged chip 100 to obtain an equivalent inductor as a tuning element, a target electrical length of the short-circuited transmission line is less than 90°. The target electrical length is an electrical length of the short-circuited transmission line at a lowest cut-off frequency in a corresponding filter passband range. For related designs of the second attenuating element S2, the second tuning element T2, the third bump BP3, a fourth bump BP4, a third solder joint PAD3, a fourth solder joint PAD4, and a second metal line Line2 in the packaging manner in Example 2, refer to related descriptions of the first attenuating element S1, the first tuning element T1, the first bump BP1, the second bump BP2, the first solder joint PAD1, the second solder joint PAD2, and the first metal line Line1 in the foregoing embodiments shown in FIG. 17 and FIG. 18. Details are not described herein again.

Example 3: Some or all elements on a coupling path may alternatively be designed outside of a packaged chip 100. A radio frequency communication module 1000 includes a packaged chip 100 and a printed circuit board 200. Therefore, the external elements may be formed on the printed circuit board 200. In this case, a metal connection structure may be designed inside the packaged chip 100, to implement an electrical connection between the coupling path and a first end and a second end of a filter resonant structure XZ1 that needs to be tuned, and an electrical connection between the coupling path and the outside components on the printed circuit board 200.

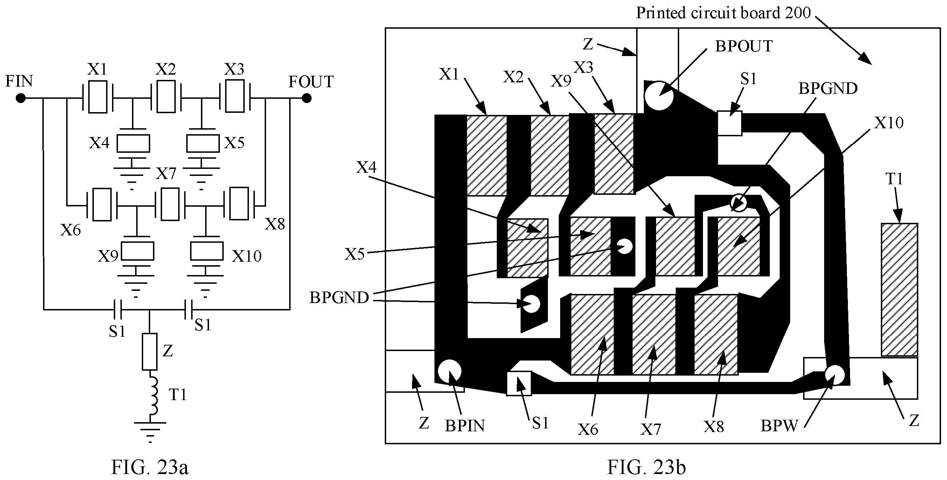

For example, a first tuning element T1 is disposed on the printed circuit board 200. As shown in FIG. 22, at least one first tuning element T1 is disposed on a printed circuit board 200. A packaged chip 100 includes a wafer 110 and a package substrate 120. A filter structure F is formed on the wafer 110, and the filter structure F includes a first filter resonant structure. A metal transmission structure includes at least one external via transmission structure V1 disposed on the package substrate 120. At least one first attenuating element S1 disposed in the packaged chip 100 is connected to a first end and a second end of the first filter resonant structure XZ1, to form a parallel structure with the first filter resonant structure XZ1. A first end of the at least one external via transmission structure V1 is connected to a transmission path formed by the first end and the second end of the first filter resonant structure XZ1 and the at least one first attenuating element S1, a second end of the at least one external via transmission structure V1 is connected to a first end of the at least one first tuning element T1 on the printed circuit board 200, and a second end of the at least one first tuning element T1 is grounded. As shown in FIG. 23a, for example, a first filter resonant structure XZ1 is a dual-passband filter resonant structure, a coupling path including two first attenuating elements S1 and one first tuning element T1 may be designed. As shown in FIG. 23b, each resonator X in the first filter resonant structure and the first attenuating elements S1 may be designed on a wafer 110. A diagram of a package substrate 120 is omitted in FIG. 23b. A metal connection structure in a packaged chip 100 may include an external via transmission structure V1, and the first attenuating element S1 in the packaged chip 100 is connected to the first tuning element T1 on a printed circuit board 200 through the external via transmission structure V1. For example, during a semiconductor design, an impedance matching design during transmission of a radio frequency signal needs to be considered. Therefore, a transmission line (transmission line) Z may be designed between the packaged chip 100 and the first tuning element T1 on the printed circuit board 200, and the transmission impedance matching design and a signal transmission design are performed based on the transmission line Z. In this case, as shown in FIG. 23a, the first tuning element T1 is connected to the first attenuating elements S1 through the transmission line Z. As shown in FIG. 23b, an external via bump BPW in the packaged chip 100 may be connected to the first tuning element T1 through the external via transmission structure V1 (disposed on the package substrate 120, and the package substrate 120 and the external via transmission structure V1 are not shown in the figure) and the transmission line Z that is designed on the printed circuit board 200.

For example, as shown in FIG. 23b, a filter structure F includes a plurality of external ends (for example, an input end FIN and an output end FOUT of a dual-passband filter, or a ground end that is in the packaged chip 100 and that is connected to a ground electrode of the printed circuit board 200). These external ends may be coupled to a plurality of external chip terminals OUT in one-to-one correspondence through an external metal connection structure (for example, including an internal bump BPIN and an external bump BPOUT). A related transmission line Z may also be designed on the printed circuit board 200 to implement impedance matching, signal transmission, and the like between these external ends and external components.

For example, the tuning element designed on the printed circuit board 200 may be a lumped inductor, a winding coil, or the like.

For technical principles and diagrams of technical effects of designing the first attenuating element S1, the second attenuating element S2, and the second tuning element T2 on the printed circuit board 200, refer to related descriptions in the foregoing embodiment in which the first tuning element T1 is designed on the printed circuit board 200. Details are not described herein again.

In the embodiment of Example 3 of this application, more design changes can be implemented by disposing the attenuating element and/or the tuning element on the printed circuit board 200. In addition, a parameter value of the tuning element may change a transmission zero of the coupling path. When the tuning element is disposed on the printed circuit board 200, the tuning element or the like may be set to an adjustable parameter structure, a replaceable structure, or the like, to meet adjustment of the transmission zero, thereby implementing performance adjustment, or implementing adaptation in different application scenarios, or the like.

In embodiments of this application, based on the foregoing coupling path including the tuning element and the attenuating element, tuning can be performed with a filter resonant structure that is connected in parallel to the coupling path, and tuning can be performed with spatial leakage at a position of the coupling path. This real-time manner has the following advantages: Advantage 1: The coupling path can generate an additional transmission zero based on a tuning function. Compared with a transmission zero generated in another related technology, the transmission zero has a larger depth, and has higher rejection and isolation for an out-of-band signal. Advantage 2: The tuning element and/or the attenuating element on the coupling path can be compatible with a mature packaging technology for processing, and can be generated synchronously in an existing processing procedure without requiring an additional processing procedure. Implementing this solution does not increase processing procedure costs or the like. Advantage 3: The coupling path does not entirely rely on an inductor to implement the transmission zero. When the inductor is used as the tuning element, a requirement on an inductance value is low, and an equivalent inductor can be integrated and designed in the packaged chip based on a semiconductor process. In this manner, integration of a component is optimized, facilitating an integration and miniaturization design of the filter component. Advantage 4: When some elements on the coupling path are designed on the printed circuit board, parameter adjustment may be implemented on the printed circuit board, so that the transmission zero of the packaged chip is changed, thereby implementing performance adjustment, application scenario adaptation adjustment, or the like.

The communication device in embodiments of this application may be a device, for example, a terminal or a chip that may be used in a terminal, configured to implement a wireless communication function. The terminal may be UE, an access terminal, a terminal unit, a terminal station, a mobile station, a remote station, a remote terminal, a mobile device, a wireless communication device, a terminal agent, a terminal apparatus, or the like in a 6G network or a future evolved public land mobile network (public land mobile network, PLMN). The access terminal may be a cellular phone, a cordless telephone, a session initiation protocol (session initiation protocol, SIP) phone, a wireless local loop (wireless local loop, WLL) station, a personal digital assistant (personal digital assistant, PDA), a handheld device with a wireless communication function, a compute device or another processing device connected to a wireless modem, a vehicle-mounted device or a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), or the like. Optionally, the communication device may be mobile or may be fixed.

In a possible implementation, the communication device in embodiments of this application may be a network device that communicates with the terminal device. The network device may include a transmission and reception point (transmission and reception point, TRP), a base station, a remote radio unit (remote radio unit, RRU) of a split base station, an active antenna unit (active antenna unit, AAU), a satellite, an uncrewed aerial vehicle, a broadband network gateway (broadband network gateway, BNG), an aggregation switch, a non-3GPP access device, a relay station, an access point, or the like.

In addition, the base station may be a base transceiver station (base transceiver station, BTS) in a global system for mobile communication (global system for mobile communication, GSM) or code division multiple access (code division multiple access, CDMA) network, an NB (NodeB) in wideband code division multiple access (wideband code division multiple access, WCDMA), an eNB or eNodeB (evolutional NodeB) in LTE, a radio controller in a cloud radio access network (cloud radio access network, CRAN) scenario, or a base station (for example, a next generation NodeB (gNodeB, gNB)) in a 5G communication system, a base station in a future evolved network, or the like. This is not specifically limited herein.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

It may be clearly understood by a person skilled in the art that, for the purpose of convenient and brief description, for a detailed working process of the foregoing system, apparatus, and module, refer to a corresponding process in the foregoing method embodiments. Details are not described herein again.

In several embodiments provided in this application, it should be understood that, the disclosed system, device, and method may be implemented in other manners. For example, the foregoing described device embodiment is merely an example. For example, division into the modules is merely logical function division and may be other division in an actual implementation. For example, a plurality of modules or components may be combined or integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate parts may or may not be physically separate, and parts displayed as modules may or may not be physical modules, that is, may be located in one device, or may be distributed in a plurality of devices. Some or all modules may be selected based on actual needs to achieve the objectives of the solutions of embodiments.

In addition, functional modules in embodiments of this application may be integrated into one device, or each of the modules may exist alone physically, or two or more modules are integrated into one device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A packaged chip, comprising a wafer, wherein the packaged chip further comprises at least one first attenuating element and at least one first tuning element, the first attenuating element is an equivalent capacitor or an equivalent resistor, and the first tuning element is an equivalent capacitor, an equivalent inductor, or an equivalent resistor, wherein
a filter structure is formed on the wafer, and the filter structure comprises a first filter resonant structure;
the at least one first attenuating element is connected to a first end and a second end of the first filter resonant structure, to form a parallel structure with the first filter resonant structure; and
a first end of each first tuning element is connected to a transmission path formed by the first end and the second end of the first filter resonant structure and the at least one first attenuating element, and a second end of each first tuning element is grounded.

2. The packaged chip according to claim 1, wherein when the at least one first attenuating element comprises a plurality of first attenuating elements, the plurality of first attenuating elements are connected in series and/or in parallel.

3. The packaged chip according to claim 1 or 2, wherein the filter structure further comprises a second filter resonant structure, and a first end of the second filter resonant structure is connected to the second end of the first filter resonant structure.

4. The packaged chip according to claim 3, wherein the packaged chip further comprises at least one second attenuating element and at least one second tuning element, the second attenuating element is an equivalent capacitor or an equivalent resistor, the second tuning element is an equivalent capacitor, an equivalent inductor, or an equivalent resistor, and the at least one second attenuating element is connected to the first end and a second end of the second filter resonant structure, to form a parallel structure with the second filter resonant structure; and
a first end of each second tuning element is connected to a transmission path formed by the first end and the second end of the second filter resonant structure and the at least one second attenuating element, and a second end of each second tuning element is grounded.

5. The packaged chip according to any one of claims 1 to 4, wherein the at least one first attenuating element and/or the at least one first tuning element are/is formed on the wafer, each first attenuating element and the filter structure are located on a same surface or different surfaces of the wafer, and each first tuning element and the filter structure are located on a same surface or different surfaces of the wafer.

6. The packaged chip according to any one of claims 1 to 4, wherein the packaged chip further comprises a package substrate, and the at least one first attenuating element and/or the at least one first tuning element are/is formed on the package substrate; the packaged chip further comprises a metal connection structure, and the metal connection structure is connected to the first end of the first filter resonant structure, the at least one first attenuating element, and the second end of the first filter resonant structure, to form a transmission path connecting the first end of the first filter resonant structure, the at least one first attenuating element, and the second end of the first filter resonant structure; and the metal connection structure is further connected to the first end of the at least one first tuning element, so that the first end of each first tuning element is connected to the transmission path formed by the first end and the second end of the first filter resonant structure and the at least one first attenuating element.

7. The packaged chip according to claim 6, wherein the at least one first tuning element is formed on the package substrate; the metal connection structure comprises a first bump, a second bump, a first solder joint, a second solder joint, and a first metal line; the first bump and the second bump are disposed on the wafer; and the first solder joint and the second solder joint are disposed on a first surface of the package substrate, wherein
the first bump is connected to the first end of the first filter resonant structure, and the second bump is connected to the second end of the first filter resonant structure; and
the first bump is bonded to the first solder joint, the second bump is bonded to the second solder joint, and the first solder joint is connected to the second solder joint through the first metal line, to form a transmission path connecting the first end of the first filter resonant structure, the first bump, the second bump, the second end of the first filter resonant structure, and the at least one first attenuating element; and the first end of each first tuning element is electrically connected to the first metal line, and the second end of the first tuning element is grounded.

8. The packaged chip according to claim 6, wherein the at least one first tuning element is formed on the package substrate, and the metal connection structure comprises a first metal jumper or a metal post, wherein
the first end of the at least one first tuning element is connected to a first end of the first metal jumper, and a second end of the first metal jumper is connected to the transmission path formed by the first end and the second end of the first filter resonant structure and the at least one first attenuating element; or
the first end of the at least one first tuning element is connected to a first end of the metal post, and a second end of the metal post is connected to the transmission path formed by the first end and the second end of the first filter resonant structure and the at least one first attenuating element.

9. The packaged chip according to claim 6, wherein a cavity structure is formed on the wafer, the filter structure is disposed in the cavity structure, and the at least one first tuning element is formed on the package substrate.

10. The packaged chip according to any one of claims 6 to 9, wherein any equivalent inductor is a winding coil or a short-circuited transmission line, a target electrical length of the short-circuited transmission line is less than 90°, and the target electrical length is an electrical length of the short-circuited transmission line at a lowest cut-off frequency in a corresponding filter passband range; and the equivalent inductor is disposed at any one of the following positions of the package substrate: the first surface of the package substrate, an inner layer of the package substrate, or a second surface of the package substrate.

11. The packaged chip according to any one of claims 6 to 9, wherein any equivalent inductor is a via structure, a first end of the via structure extends from an inner layer of the package substrate to the first surface of the package substrate, the first end of the via structure is connected to the first metal transmission line, and a second end of the via structure is grounded.

12. The packaged chip according to any one of claims 6 to 11, wherein the at least one first attenuating element is disposed at any one of the following positions of the package substrate: the first surface of the package substrate, the inner layer of the package substrate, or the second surface of the package substrate.

13. The packaged chip according to any one of claims 1 to 12, wherein the filter structure comprises a plurality of external ends, and a plurality of external metal connection structures are further disposed on a second surface of the wafer; and the plurality of external ends are connected to first ends of the plurality of external metal connection structures in one-to-one correspondence, second ends of the plurality of external via transmission structures extend to outside the package substrate and are coupled to a plurality of external chip terminals in one-to-one correspondence, and the plurality of external chip terminals are external communication ports of the packaged chip.

14. The packaged chip according to any one of claims 1 to 13, wherein the packaged chip is a filter chip, a different-frequency power splitter chip, a multiplexer chip, an integrated radio frequency switch, or an amplifier.

15. A radio frequency communication module, comprising a printed circuit board, a packaged chip, and a metal connection structure, wherein the packaged chip further comprises at least one first attenuating element, the printed circuit board is provided with a first tuning element, the first attenuating element is an equivalent capacitor or an equivalent resistor, and the first tuning element is an equivalent capacitor, an equivalent inductor, or an equivalent resistor; the packaged chip comprises a wafer and a package substrate; a filter structure is formed on the wafer, and the filter structure comprises a first filter resonant structure; and the package substrate is provided with at least one external via transmission structure, wherein
the at least one first attenuating element is connected to a first end and a second end of the first filter resonant structure, to form a parallel structure with the first filter resonant structure; and
a first end of the at least one external via transmission structure is connected to a transmission path formed by the first end and the second end of the first filter resonant structure and the at least one first attenuating element, a second end of the at least one external via transmission structure is connected to a first end of the at least one first tuning element, and a second end of the at least one first tuning element is grounded.

16. The radio frequency communication module according to claim 15, wherein when the at least one first attenuating element comprises a plurality of first attenuating elements, the plurality of first attenuating elements are connected in series and/or in parallel.

17. The radio frequency communication module according to claim 15 or 16, wherein the first attenuating element is disposed at any one of the following positions of the radio frequency communication module: the wafer, the package substrate, and the printed circuit board.

18. The radio frequency communication module according to any one of claims 15 to 17, wherein the packaged chip is at least one of the following: a filter chip, a different-frequency power splitter chip, a multiplexer chip, an integrated radio frequency switch, or an amplifier.

19. A radio frequency communication module, comprising a printed circuit board and the packaged chip according to any one of claims 1 to 14.

20. A communication device, comprising a device housing and a radio frequency communication module, wherein the radio frequency communication module is partially or entirely disposed in the device housing, and the radio frequency communication module is the radio frequency communication module according to any one of claims 15 to 18, or the radio frequency communication module according to claim 19.
